# EUROPEAN PATENT APPLICATION

(11) **EP 3 770 985 A1**
(43) Date of publication of application: **27.01.2021**
(21) Application number: 19771132.8
(22) Date of filing: 05.03.2019
(51) Int. Cl.: H01L 51/50

(54) **ORGANIC ELECTROLUMINESCENCE ELEMENT**

(30) Priority: 19.03.2018 JP 2018050742
(71) Applicant: NIPPON STEEL Chemical & Material Co., Ltd., Tokyo 103-0027 (JP)
(72) Inventor: UEDA, Tokiko, Tokyo 103-0027 (JP); SAWADA, Yuichi, Tokyo 103-0027 (JP)
(74) Representative: Beckmann, Claus
(86) International application number: PCT/JP2019/008491
(87) International publication number: WO 2019/181465

(57) **Abstract**

Provided is an organic EL device, which shows high luminous efficiency, low voltage, and high driving stability. The organic EL device is an organic electroluminescent device having laminated, on a substrate, an anode, organic layers, and a cathode, wherein at least one layer of the organic layers uses materials including a carborane compound having a carborane ring and a biscarbazole ring, and an indolocarbazole compound having one or two indolocarbazole rings. The carborane compound is represented by the following general formula (1) where H_{A} represents a carborane ring-containing group.

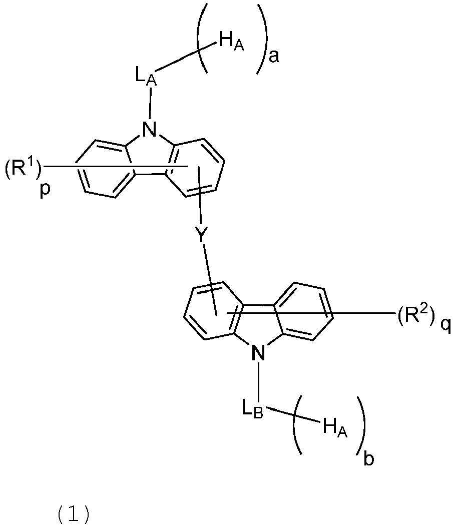

## Description

### Technical Field

The present invention relates to an organic electroluminescent device (hereinafter referred to as organic EL device), and more specifically, to an organic EL device including an organic layer containing a plurality of compounds.

### Background Art

In general, an organic EL device includes a light-emitting layer and a pair of counter electrodes interposing the light-emitting layer therebetween in its simplest structure. That is, the organic EL device uses such a phenomenon that, when an electric field is applied between both the electrodes, electrons are injected from a cathode and holes are injected from an anode, and each electron and each hole recombine in the light-emitting layer to emit light as energy.

With regard to excitons to be produced at the time of the recombination, according to the statistical law of electron spins, singlet excitons and triplet excitons are produced at a ratio of 1:3. The internal quantum efficiency of a fluorescent emission-type organic EL device using light emission by a singlet exciton is said to be at most 25%. Meanwhile, it has been known that the internal quantum efficiency of a phosphorescent emission-type organic EL device, which uses an iridium complex and uses light emission by a triplet exciton, can be theoretically improved to 100% when intersystem crossing from a singlet exciton is efficiently performed.

In addition, in recent years, a high-efficiency organic EL device utilizing delayed fluorescence has been developed. In, for example, Patent Literature 1, there is a disclosure of an organic EL device utilizing a thermally activated delayed fluorescence (TADF) mechanism. The mechanism is an approach by which the internal quantum efficiency of the device can be improved, but a further improvement in lifetime characteristic thereof has been required as in the phosphorescent emission-type device.

To improve the characteristics of those organic EL devices, such devices as disclosed in Patent literatures 2 to 6, the devices including biscarbazoles or carborane compounds in their organic layers, have been investigated.

### Citation List

### Patent Literature

[PTL 1] WO 2011/070963 A1
[PTL 2] JP 2003-133075 A
[PTL 3] JP 2005-166574 A
[PTL 4] WO 2015/137202 A1
[PTL 5] WO 2013/062075 A1
[PTL 6] US 2014/0374728 A1
[PTL 7] WO 2017/169355 A1

In Patent Literature 2, there is a disclosure that a biscarbazole compound is used as a host material. In Patent Literature 3, there is a disclosure that a carborane compound is used as a host material. In Patent Literature 4, there is a disclosure that a specific carborane compound is used as a delayed fluorescent light-emitting material or a host material in a light-emitting layer, and in each of Patent Literatures 5 and 6, there is a disclosure that a specific biscarbazole compound and a specific indolocarbazole compound are used as a mixed host material. In Patent Literature 7, there is a disclosure that a specific biscarbazole compound and a biscarbazole compound substituted with carborane are used as a mixed host material. In each of those literatures, however, there is no teaching of the use of the mixture of a biscarbazole compound substituted with carborane and an indolocarbazole compound in an organic layer except a light-emitting layer or as a host material for the light-emitting layer.

### Disclosure of Invention

In order to apply an organic EL device to a display device in a flat panel display or the like, it is necessary to improve the luminous efficiency of the device and also to ensure sufficiently the stability in driving the device. The present invention has an object to provide, in view of the above-mentioned circumstances, a practically useful organic EL device that has high efficiency and high driving stability while being driven at a low voltage.

The present invention relates to an organic electroluminescent device having laminated, on a substrate, an anode, organic layers, and a cathode, wherein at least one layer of the organic layers contains (i) a first compound represented by the following general formula (1) and (ii) a second compound represented by the following general formula (2) or general formula (3):

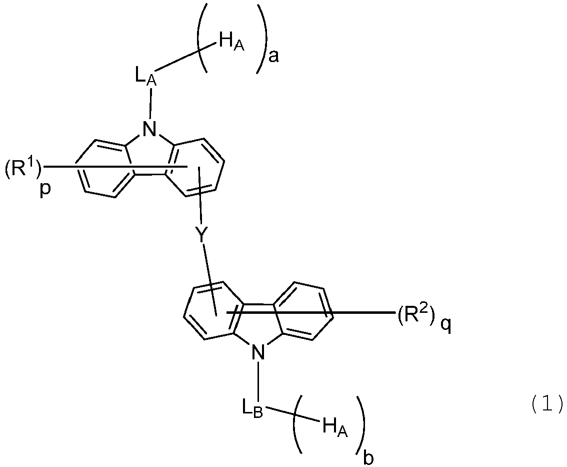

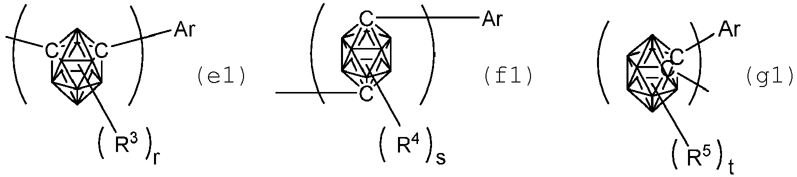

in the general formula (1):
H_{A} represents a carborane ring-containing group represented by the formula (e1), the formula (f1), or the formula (g1), and when the plurality of groups are present in a molecule of the compound, the groups may be identical to or different from each other;
Ars each independently represent hydrogen, a substituted or unsubstituted aromatic hydrocarbon group having 6 to 30 carbon atoms, a substituted or unsubstituted aromatic heterocyclic group having 3 to 16 carbon atoms, a substituted or unsubstituted linked aromatic group obtained by linking 2 to 6 aromatic rings of the aromatic hydrocarbon group or the aromatic heterocyclic group, an alkyl group having 1 to 20 carbon atoms, or an aralkyl group having 7 to 38 carbon atoms;
R¹ to R⁵ each independently represent a substituted or unsubstituted aromatic hydrocarbon group having 6 to 30 carbon atoms, a substituted or unsubstituted aromatic heterocyclic group having 3 to 16 carbon atoms, a substituted or unsubstituted linked aromatic group obtained by linking 2 to 6 aromatic rings of the aromatic hydrocarbon group or the aromatic heterocyclic group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, a cyano group, a nitro group, a fluoro group, or a tosyl group, and in a case of a group except the cyano group, the nitro group, the fluoro group, and the tosyl group, the group may further have a substituent;
Y represents a single bond, a divalent substituted or unsubstituted aromatic hydrocarbon group having 6 to 30 carbon atoms, a divalent substituted or unsubstituted aromatic heterocyclic group having 3 to 16 carbon atoms, or a divalent substituted or unsubstituted linked aromatic group obtained by linking 2 to 6 aromatic rings of the aromatic hydrocarbon group or the aromatic heterocyclic group;
L_{A} and L_{B} each represent a single bond, a substituted or unsubstituted aromatic hydrocarbon group having 6 to 30 carbon atoms, a substituted or unsubstituted aromatic heterocyclic group having 3 to 30 carbon atoms, or a substituted or unsubstituted linked aromatic group obtained by linking 2 to 6 aromatic rings of the aromatic hydrocarbon group or the aromatic heterocyclic group, provided that L_{A} represents an a+1-valent group and L_{B} represents a b+1-valent group, and when a or b represents 0, L_{A} or L_{B} may represent hydrogen, and when a or b represents 1, L_{A} or L_{B} may represent a single bond; and
p, q, r, s, t, a, and b each represent a substitution number, p and q each independently represent an integer of from 0 to 7, r, s, and t each independently represent an integer of from 0 to 10, a and b each independently represent an integer of from 0 to 5, and a+b represents an integer of from 1 to 5; 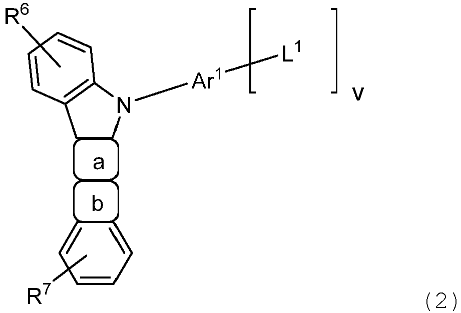 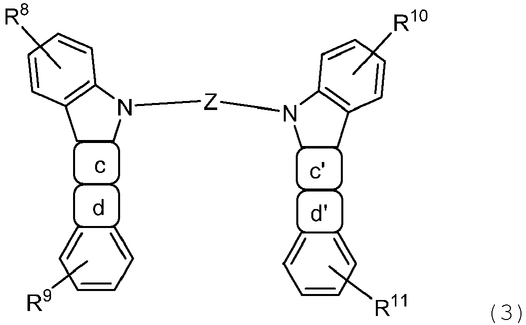 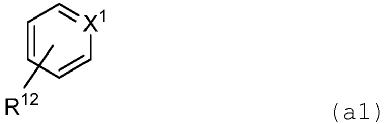 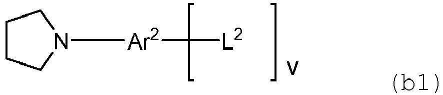
where:
a ring a, a ring c, and a ring c' each independently represent an aromatic ring represented by the formula (a1), which is fused with two adjacent rings at arbitrary positions, and X¹ represents C-R or N;
a ring b, a ring d, and a ring d' each independently represent a heterocycle represented by the formula (b1), which is fused with two adjacent rings at arbitrary positions;
Ar¹ and Ar² each independently represent a v+1-valent aromatic hydrocarbon group having 6 to 30 carbon atoms, or a v+1-valent aromatic heterocyclic group having 3 to 16 carbon atoms, and Z represents a divalent aromatic hydrocarbon group having 6 to 30 carbon atoms, a divalent aromatic heterocyclic group having 3 to 16 carbon atoms, or a divalent linked aromatic group obtained by linking 2 to 10 aromatic rings of the aromatic hydrocarbon group or the aromatic heterocyclic group;
L¹ and L² each independently represent an aromatic hydrocarbon group having 6 to 30 carbon atoms, an aromatic heterocyclic group having 3 to 16 carbon atoms, or a linked aromatic group obtained by linking 2 to 10 aromatic rings of the aromatic hydrocarbon group or the aromatic heterocyclic group, and v s each independently represent a substitution number, and each independently represent an integer of from 0 to 7;
R⁶ to R¹² each independently represent hydrogen, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 30 carbon atoms, or an aromatic heterocyclic group having 3 to 16 carbon atoms, and when any one of R⁶ to R¹² represents a phenyl group, the phenyl group may be fused with an aromatic ring substituted with the phenyl group to form a fused ring; and
when Ar¹, Ar², Z, L¹, L², and R⁶ to R¹² represent groups except hydrogen, the groups may each have a substituent.

A preferred mode of the general formula (1) is described below.

H_{A} represents the formula (e1) or the formula (f1). a represents an integer of from 0 to 2. p and q each independently represent an integer of from 0 to 3. r, s, and t each independently represent an integer of from 0 to 3. Alternatively, the compound has a carborane group represented by the formula (e1).

A preferred mode of the organic electroluminescent device of the present invention is described below.

The organic layer containing the first compound and the second compound is at least one layer selected from the group consisting of a light-emitting layer containing a light-emitting dopant, an electron-blocking layer, and a hole-blocking layer. The organic layer is the light-emitting layer containing the light-emitting dopant, and contains the first compound and the second compound as host materials. The light-emitting dopant is a delayed fluorescent light-emitting dopant. Alternatively, the light-emitting dopant is an organometallic complex containing at least one metal selected from ruthenium, rhodium, palladium, silver, rhenium, osmium, iridium, platinum, and gold.

To improve the characteristics of the organic EL device, it is important to suppress the leakage of an exciton and a charge to a peripheral layer. The alleviation of the bias of a light-emitting region in the light-emitting layer is effective in suppressing the leakage of the charge /or the exciton, and the control of the injection quantities of both charges (an electron / a hole) within preferred ranges is needed for the alleviation.

Herein, the indolocarbazole compounds typified by the general formulae (2) and (3) each have high skeleton stability, and hence their electron /or hole-injecting or transporting properties can be controlled to some extent by an isomer or a substituent. However, with any such indolocarbazole compound alone, it is difficult to control the injection quantities of both the charges within preferred ranges as described above. Meanwhile, when the compound is mixed with the specific carborane compound typified by the general formula (1), and the mixture is used as a mixed host, the injection quantities of both the charges can be controlled. In addition, the carborane compound has high skeleton stability as in the indolocarbazole compounds. In particular, when the carborane compound is used in the light-emitting layer, a balance between the injection quantities of both the charges can be adjusted. In the case of a delayed fluorescent light-emitting EL device or a phosphorescent light-emitting EL device, the carborane compound has the lowest excited triplet energy high enough to confine an excitation energy generated in its light-emitting layer. Accordingly, the outflow of the energy from the inside of the light-emitting layer does not occur, and hence the device can achieve high efficiency and a long lifetime at a low voltage.

### Brief Description of Drawings

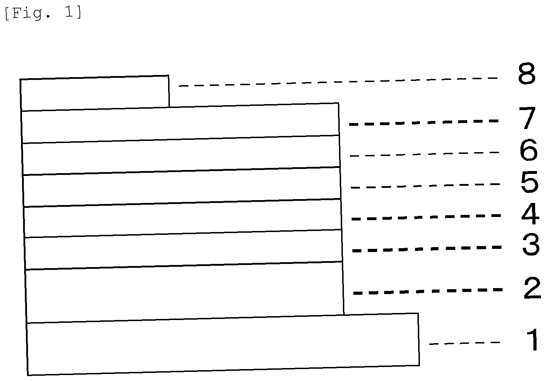

FIG. 1 is a schematic sectional view for illustrating an example of an organic EL device.

### Description of Embodiments

An organic electroluminescent device of the present invention is an organic electroluminescent device having laminated, on a substrate, an anode, organic layers, and a cathode, wherein at least one layer of the organic layers contains (i) a compound represented by the general formula (1) and (ii) a compound represented by the general formula (2) or (3). The compounds represented by the general formula (1) and the general formula (2) or (3) may each be one kind of compound, or may each be two or more kinds of compounds . The ratio of the compound represented by the general formula (1) is preferably 30 wt% or more with respect to the total of the compound represented by the general formula (1) and the compound represented by the general formula (2) or (3) (also referred to as indolocarbazole compound) . The ratio is more preferably from 35 wt% to 95 wt%, still more preferably from 40 wt% to 90 wt%.

The general formula (1) is described.

H_{A} represents a carborane ring-containing group represented by the formula (e1), the formula (f1), or the formula (g1), and when the plurality of groups are present in a molecule of the compound represented by the general formula (1), the groups may be identical to or different from each other. H_{A} represents preferably a carborane ring-containing group represented by the formula (e1) or the formula (f1), more preferably a carborane ring-containing group represented by the formula (e1). The number of the carborane ring-containing groups in the molecule is one or more, but is preferably one or two.

Ars each independently represent hydrogen, an aromatic hydrocarbon group having 6 to 30 carbon atoms, an aromatic heterocyclic group having 3 to 16 carbon atoms, a linked aromatic group obtained by linking 2 to 6 aromatic rings of the aromatic hydrocarbon group or the aromatic heterocyclic group, an alkyl group having 1 to 20 carbon atoms, or an aralkyl group having 7 to 38 carbon atoms. It is preferred that Ars each represent hydrogen, an aromatic hydrocarbon group having 6 to 20 carbon atoms, an aromatic heterocyclic group having 3 to 12 carbon atoms, or a linked aromatic group obtained by linking 2 or 3 aromatic rings of the aromatic hydrocarbon group or the aromatic heterocyclic group. Herein, the aromatic hydrocarbon group, the aromatic heterocyclic group, and the linked aromatic group may each have a substituent.

L_{A} represents a single bond or an a+1-valent group, and L_{B} represents a single bond or a b+1-valent group. In the case of an a+1-valent group or a b+1-valent group, L_{A} or L_{B} represents an aromatic hydrocarbon group having 6 to 30 carbon atoms, an aromatic heterocyclic group having 3 to 30 carbon atoms, or a linked aromatic group obtained by linking 2 to 6 aromatic rings of the aromatic hydrocarbon group or the aromatic heterocyclic group. However, when a or b represents 0, L_{A} and L_{B} may each represent hydrogen, and when a or b represents 1, L_{A} and L_{B} may each represent a single bond. It is preferred that L_{A} and L_{B} each represent a single bond, an aromatic hydrocarbon group having 6 to 20 carbon atoms, an aromatic heterocyclic group having 3 to 12 carbon atoms, or a linked aromatic group obtained by linking 2 or 3 aromatic rings of the aromatic hydrocarbon group or the aromatic heterocyclic group. Herein, the aromatic hydrocarbon group, the aromatic heterocyclic group, and the linked aromatic group may each have a substituent.

p, q, r, s, t, a, and b each represent a substitution number, p and q each independently represent an integer of from 0 to 7, r, s, and t each independently represent an integer of from 0 to 10, a and b each independently represent an integer of from 0 to 5, and a+b represents an integer of from 1 to 5.
p and q each represent preferably an integer of from 0 to 5, more preferably an integer of from 0 to 3. r, s, and t each preferably represent an integer of from 0 to 3. a and b each represent preferably an integer of from 0 to 3, more preferably an integer of from 0 to 2. a+b represents an integer of from 0 to 7, preferably 1, 2, or 3.

Y represents a single bond or a divalent group. Y represents, as a divalent group, an aromatic hydrocarbon group having 6 to 30 carbon atoms, an aromatic heterocyclic group having 3 to 30 carbon atoms, or a substituted or unsubstituted linked aromatic group obtained by linking 2 to 6 aromatic rings of the aromatic hydrocarbon group or the aromatic heterocyclic group. Y represents preferably a single bond, an aromatic hydrocarbon group having 6 to 18 carbon atoms, an aromatic heterocyclic group having 3 to 17 carbon atoms, or a linked aromatic group obtained by linking 2 to 5 aromatic rings of the aromatic hydrocarbon group or the aromatic heterocyclic group, more preferably a single bond or a phenylene group. The linked aromatic group is a group formed through the linking of 2 to 6 aromatic rings of the aromatic hydrocarbon group or the aromatic heterocyclic group by direct bonding, and may have the same substituent as that of the aromatic hydrocarbon group or the aromatic heterocyclic group. The aromatic hydrocarbon group, the aromatic heterocyclic group, and the linked aromatic group are collectively referred to as aromatic groups. In addition, the aromatic hydrocarbon group, the aromatic heterocyclic group, and the linked aromatic group may each have a substituent.

R¹ to R⁵ each independently represent an aromatic hydrocarbon group having 6 to 30 carbon atoms, an aromatic heterocyclic group having 3 to 16 carbon atoms, a linked aromatic group obtained by linking 2 to 6 aromatic rings of the aromatic hydrocarbon group or the aromatic heterocyclic group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, a cyano group, a nitro group, a fluoro group, or a tosyl group.

In addition, in the case of a group except the cyano group, the nitro group, the fluoro group, and the tosyl group, the group may further have a substituent. That is, in the case of any one of the aromatic hydrocarbon group, the aromatic heterocyclic group, the linked aromatic group, the alkyl group, the aralkyl group, the alkenyl group, the alkynyl group, the dialkylamino group, the diarylamino group, the diaralkylamino group, the acyl group, the acyloxy group, the alkoxy group, the alkoxycarbonyl group, the alkoxycarbonyloxy group, and the alkylsulfonyl group, the group may have a substituent.

When Ar, L_{A}, L_{B}, Y, and R¹ to R⁵ each represent an unsubstituted aromatic hydrocarbon group, aromatic heterocyclic group, or linked aromatic group, specific examples thereof include: a group produced by removing a hydrogen atom from an aromatic hydrocarbon compound, such as benzene, pentalene, indene, naphthalene, fluorene, azulene, heptalene, octalene, indacene, acenaphthylene, phenalene, phenanthrene, anthracene, trindene, fluoranthene, acephenanthrylene, aceanthrylene, triphenylene, pyrene, chrysene, tetraphene, tetracene, pleiadene, picene, perylene, pentaphene, pentacene, tetraphenylene, cholanthrylene, a helicene, hexaphene, rubicene, coronene, trinaphthylene, heptaphene, or pyranthrene; a group produced by removing a hydrogen atom from an aromatic heterocyclic compound, such as furan, benzofuran, isobenzofuran, xanthene, oxanthrene, dibenzofuran, peri-xanthenoxanthene, thiophene, thioxanthene, thianthrene, phenoxathiin, thionaphthene, isothianaphthene, thiophthene, thiophanthrene, dibenzothiophene, pyrrole, pyrazole, tellurazole, selenazole, thiazole, isothiazole, oxazole, furazan, pyridine, pyrazine, pyrimidine, pyridazine, triazine, indolizine, indole, isoindole, indazole, purine, quinolizine, isoquinoline, carbazole, imidazole, naphthyridine, phthalazine, quinazoline, azepine, benzodiazepine, tribenzoazepine, quinoxaline, cinnoline, quinoline, pteridine, phenanthridine, acridine, perimidine, phenanthroline, phenazine, carboline, phenotellurazine, phenoselenazine, phenothiazine, phenoxazine, anthyridine, benzothiazole, benzimidazole, benzoxazole, benzisoxazole, benzisothiazole, dibenzophosphole, or dibenzoborole; and a linked aromatic group produced by removing a hydrogen atom from an aromatic compound in which a plurality of aromatic rings of these aromatic compounds are linked to each other.

The group is preferably, for example, a group produced by removing a hydrogen atom from benzene, naphthalene, anthracene, fluorene, phenanthrene, triphenylene, pyridine, pyrimidine, triazine, dibenzofuran, dibenzothiophene, or carbazole, or a linked aromatic group produced by removing a hydrogen atom from an aromatic compound in which a plurality of aromatic rings of these aromatic compounds are linked to each other.

When the aromatic hydrocarbon group, the aromatic heterocyclic group, the linked aromatic group, the alkyl group, or the like has a substituent, the substituent is an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, a cyano group, a nitro group, a fluoro group, or a tosyl group, preferably an alkyl group having 1 to 12 carbon atoms, an aralkyl group having 7 to 20 carbon atoms, a diarylamino group having 12 to 30 carbon atoms, an alkoxy group having 1 to 10 carbon atoms, a cyano group, a fluoro group, or a tosyl group. The alkyl group may be linear, branched, or cyclic.

Specific examples of the substituent include: an alkyl group, such as methyl, ethyl, propyl, butyl, pentyl, cyclopentyl, hexyl, cyclohexyl, heptyl, octyl, nonyl, decyl, undecyl, dodecyl, tridecyl, tetradecyl, pentadecyl, hexadecyl, heptadecyl, octadecyl, nonadecyl, or icosyl; an aralkyl group, such as phenylmethyl, phenylethyl, phenylicosyl, naphthylmethyl, anthranylmethyl, phenanthrenylmethyl, or pyrenylmethyl; an alkenyl group, such as vinyl, propenyl, butenyl, pentenyl, decenyl, or icosenyl; an alkynyl group, such as ethynyl, propargyl, butynyl, pentynyl, decynyl, or icosynyl; a dialkylamino group, such as dimethylamino, ethylmethylamino, diethylamino, dipropylamino, dibutylamino, dipentynylamino, didecylamino, or diicosylamino; a diarylamino group, such as diphenylamino, naphthylphenylamino, dinaphthylamino, dianthranylamino, diphenanthrenylamino, or dipyrenylamino; a diaralkylamino group, such as diphenylmethylamino, diphenylethylamino, phenylmethylphenylethylamino, dinaphthylmethylamino, dianthranylmethylamino, or diphenanthrenylmethylamino; an acyl group, such as acetyl, propionyl, butyryl, valeryl, or benzoyl; an acyloxy group, such as acetyloxy, propionyloxy, butyryloxy, valeryloxy, orbenzoyloxy; an alkoxy group, such as methoxy, ethoxy, propoxy, butoxy, pentoxy, hexoxy, heptoxy, octoxy, nonyloxy, or decanyloxy; an alkoxycarbonyl group, such as methoxycarbonyl, ethoxycarbonyl, propoxycarbonyl, butoxycarbonyl, or pentoxycarbonyl; an alkoxycarbonyloxy group, such as methoxycarbonyloxy, ethoxycarbonyloxy, propoxycarbonyloxy, butoxycarbonyloxy, or pentoxycarbonyloxy; an alkylsulfoxy group, such as methylsulfonyl, ethylsulfonyl, propylsulfonyl, butylsulfonyl, or pentylsulfonyl; a cyano group; a nitro group; a fluoro group; and a tosyl group. The substituent is preferably, for example, an alkyl group having 1 to 12 carbon atoms, an aralkyl group having 7 to 20 carbon atoms, an alkoxy group having 1 to 10 carbon atoms, a diarylamino group having two aromatic hydrocarbon groups each having 6 to 15 carbon atoms, a cyano group, a fluoro group, or a tosyl group.

The term linked aromatic group as used herein refers to a group obtained by linking a plurality of aromatic rings (referring to an aromatic hydrocarbon ring, an aromatic heterocycle, or both of the ring and the heterocycle) of aromatic compounds each having a monocyclic or fused ring structure. The phrase aromatic rings are linked means that the aromatic rings of aromatic groups are linked by being bonded to each other by direct bonding. When any such aromatic ring is a substituted aromatic ring, its substituent is not an aromatic ring.

The linked aromatic group may be linear or branched, and the aromatic rings to be linked may be identical to or different from each other. The aromatic rings to be linked may include one or both of an aromatic hydrocarbon ring and an aromatic heterocycle, and may each have a substituent.

When the linked aromatic group is a monovalent group, its linking mode is, for example, any one of those represented below.

**-Ar¹¹-Ar¹²-Ar¹³** (9)

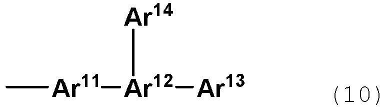

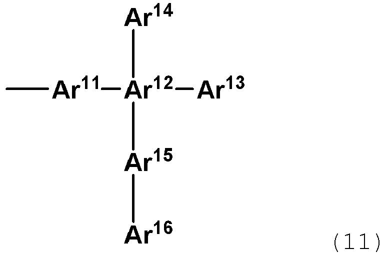

When the linked aromatic group is a divalent group, its linking mode is, for example, any one of those represented below. When the linked aromatic group is a group that is trivalent or more, its linking mode is understood from the foregoing.

-Ar²¹-Ar²²-Ar²³- (12)

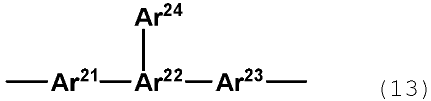

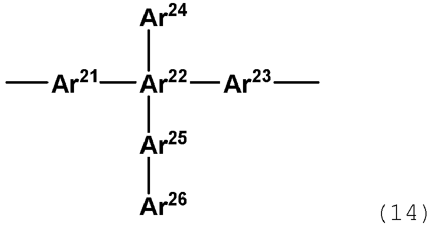

In the formulae (9) to (14), Ar¹¹ to Ar¹⁶ and Ar²¹ to Ar²⁶ each represent a substituted or unsubstituted aromatic ring (aromatic group), and the ring-forming atoms of the aromatic rings are bonded to each other by direct bonding. In addition, a bonding hand is provided from a ring-forming atom of an aromatic ring. The aromatic ring (aromatic group) means an aromatic hydrocarbon group or an aromatic heterocyclic group, and may be a group that is monovalent or more.

Although a bonding hand is provided from Ar¹¹, Ar²¹, or Ar²³ in the formulae (9) to (14), a bonding hand may be provided from an aromatic ring except the foregoing. In addition, when the linked aromatic group is a group that is divalent or more, two or more bonding hands may be provided from one aromatic ring.

Specific examples of the linked aromatic group include groups each produced by removing one or one or more hydrogen atoms from an aromatic compound, such as biphenyl, terphenyl, bipyridine, bipyrimidine, bitriazine, terpyridine, phenylterphenyl, binaphthalene, phenylpyridine, diphenylpyridine, phenylpyrimidine, diphenylpyrimidine, phenyltriazine, diphenyltriazine, phenylnaphthalene, diphenylnaphthalene, carbazolylbenzene, biscarbazolylbenzene, biscarbazolyltriazine, dibenzofuranylbenzene, bisdibenzofuranylbenzene, dibenzothiophenylbenzene, or bisdibenzothiophenylbenzene.

The foregoing description concerning the linked aromatic group is common to linked aromatic groups appearing in descriptions in the general formulae (1) to (3).

In this description, the calculation of the number of carbon atoms is understood as being free of the number of the carbon atoms of a substituent. However, it can be said that the total number of carbon atoms including the number of the carbon atoms of the substituent preferably falls within the range of the number of carbon atoms described above. The number of the carbon atoms of the linked aromatic group is understood as the sum of the numbers of the carbon atoms of the aromatic hydrocarbon group or the aromatic heterocyclic group to be linked.

The compound represented by the general formula (1) is known in Patent Literature 7 or the like, and may be synthesized by combining known reactions. For example, the compound may be produced by combining a method of synthesizing a carborane compound described in WO 2015/137202 A1 and a method of synthesizing a biscarbazole compound described in JP 08-3547 A or WO 2012/153725 A1.

Preferred specific examples of the compound represented by the general formula (1) are shown below, but the compound is not limited thereto.

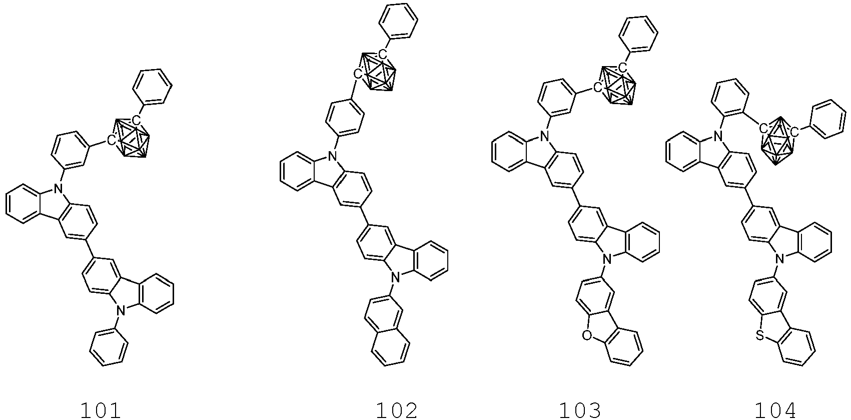

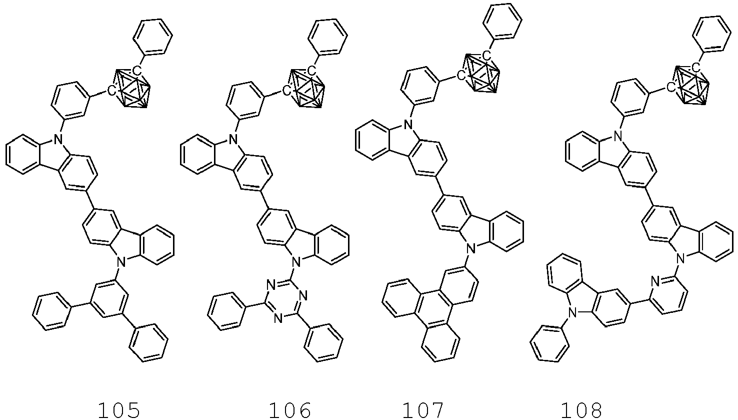

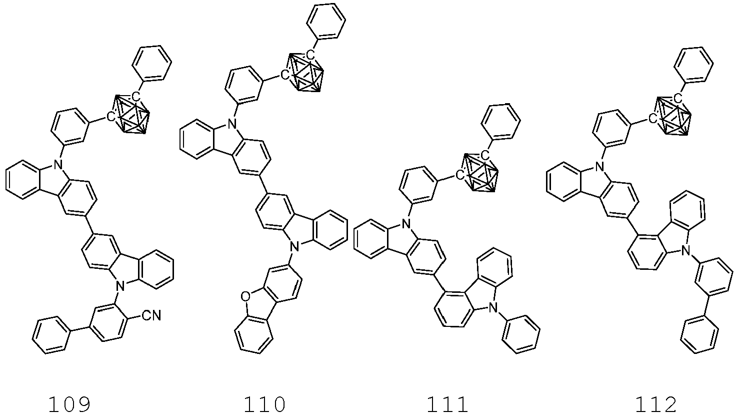

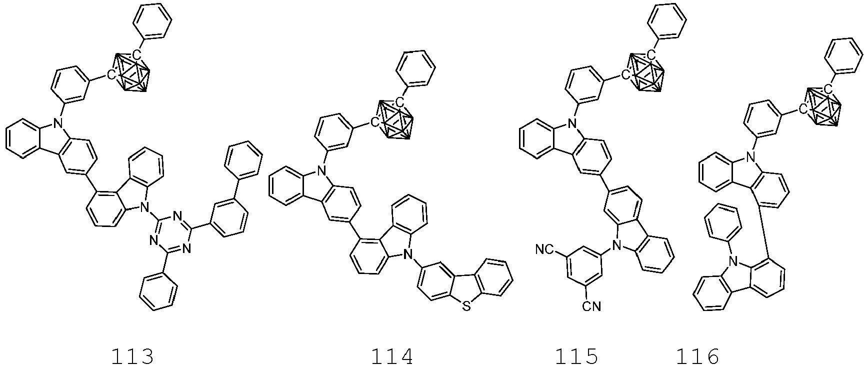

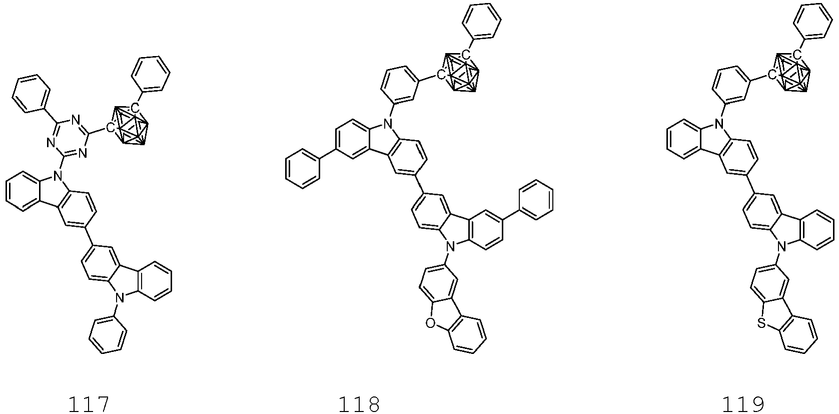

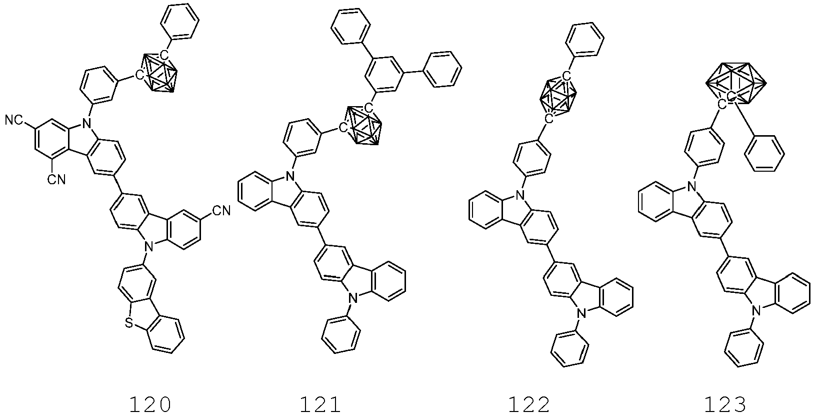

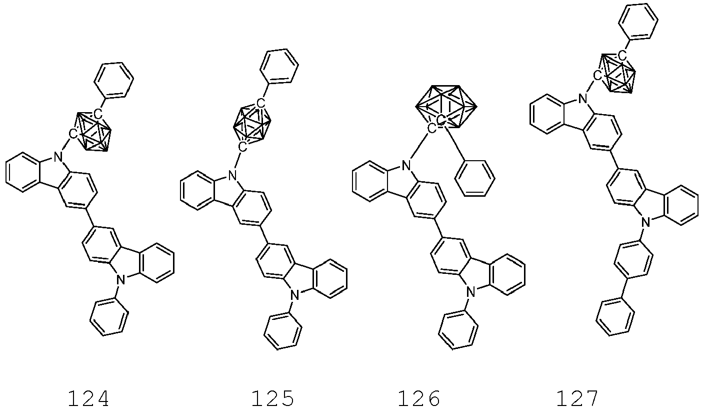

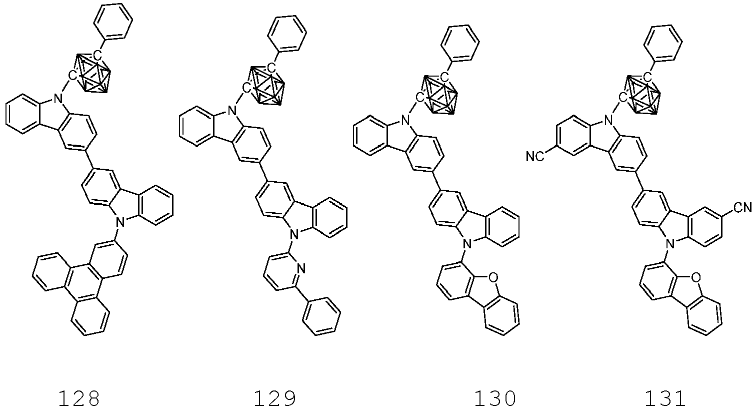

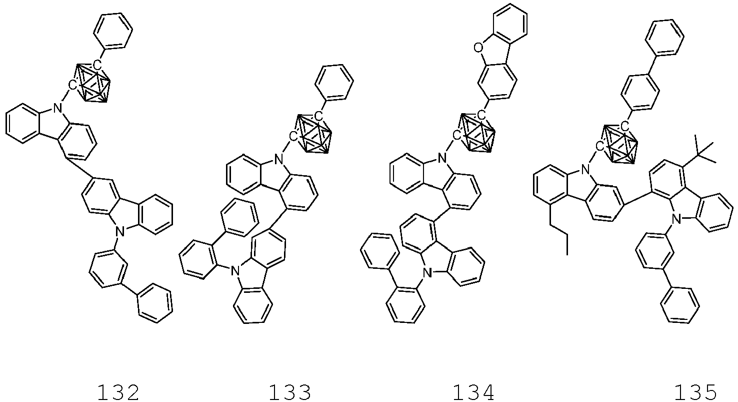

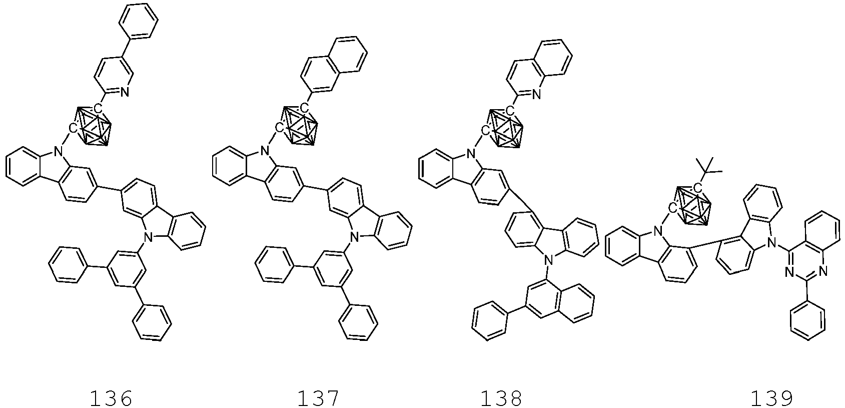

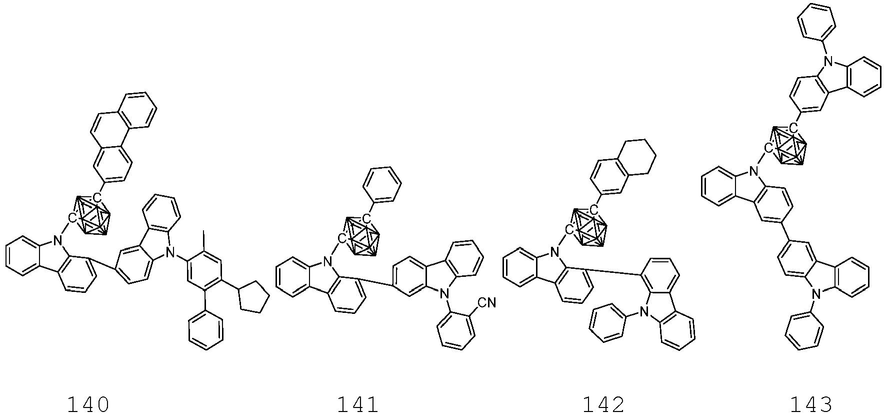

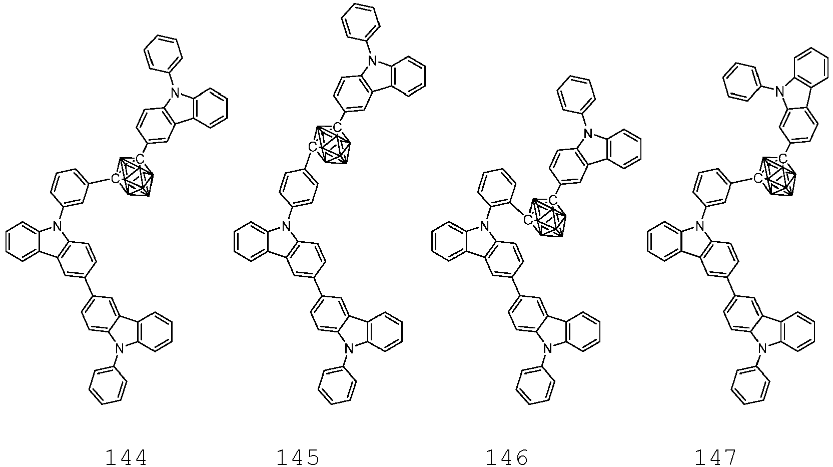

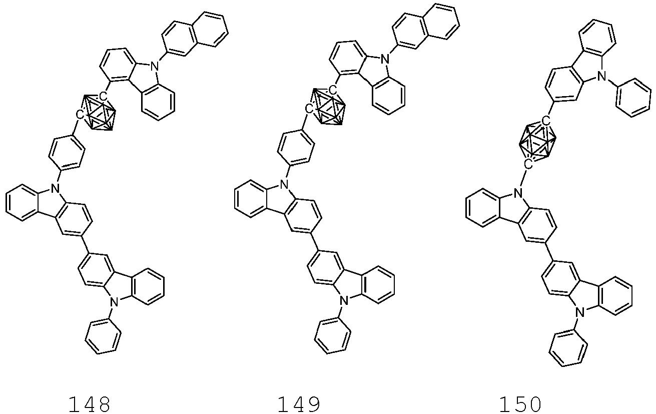

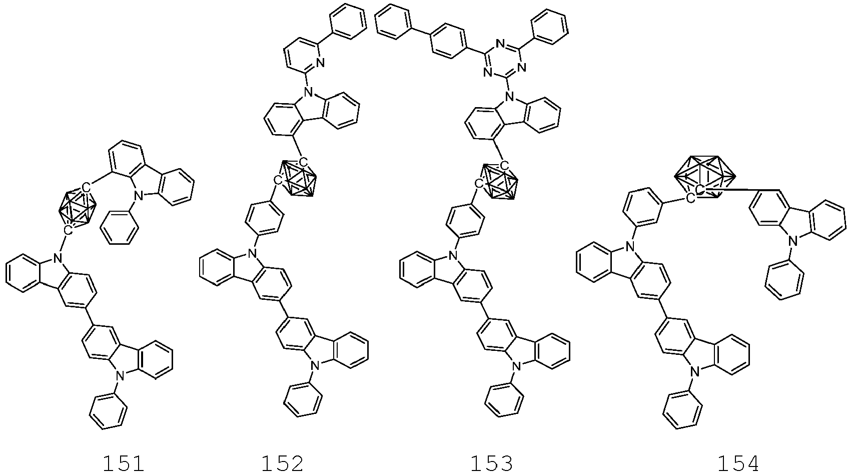

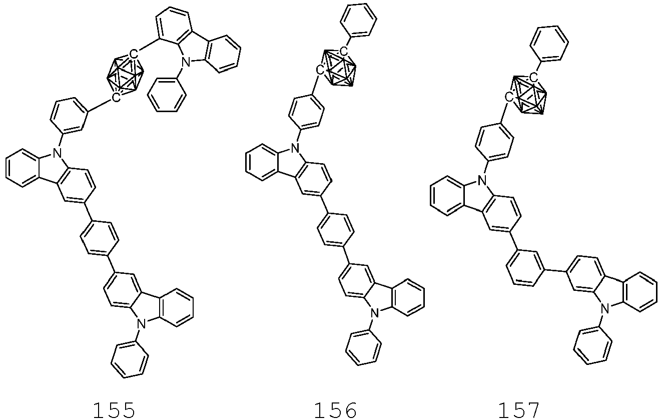

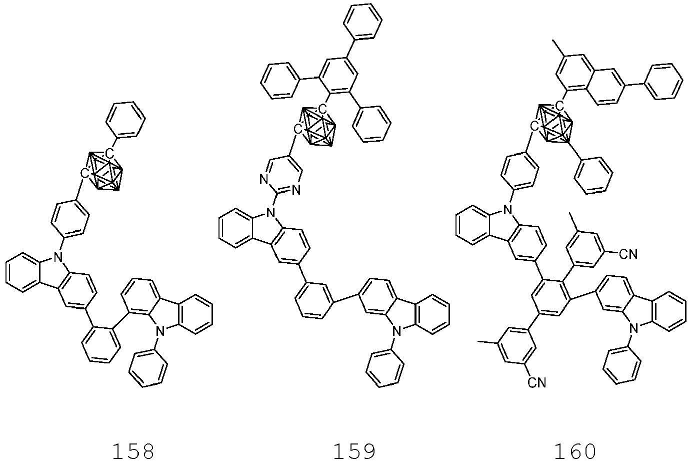

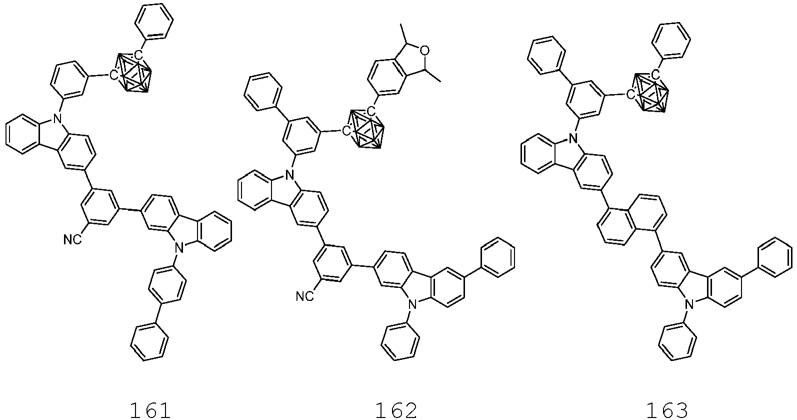

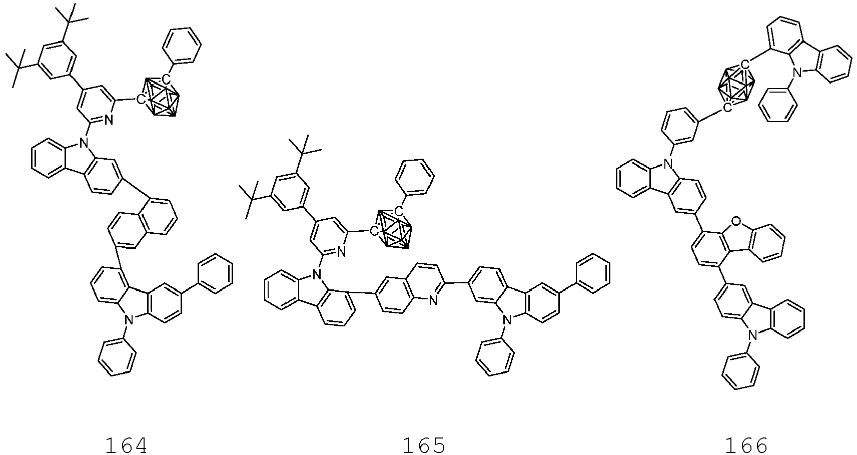

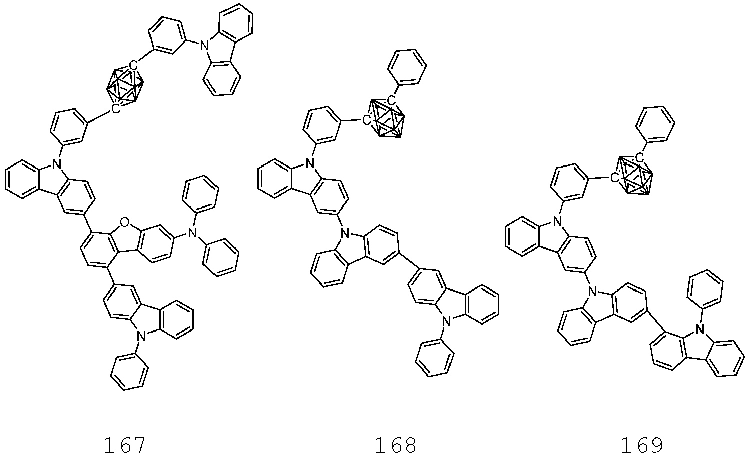

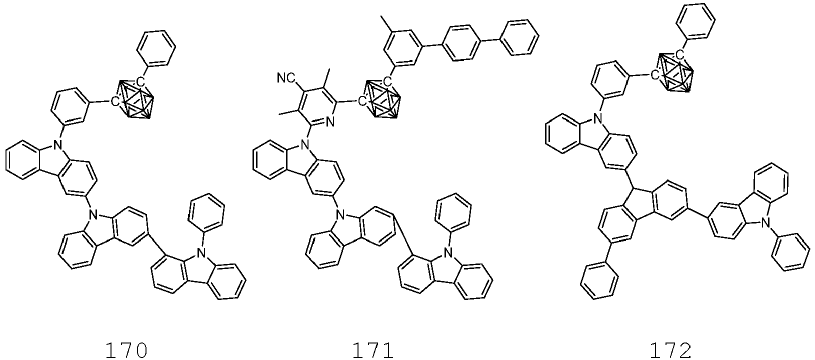

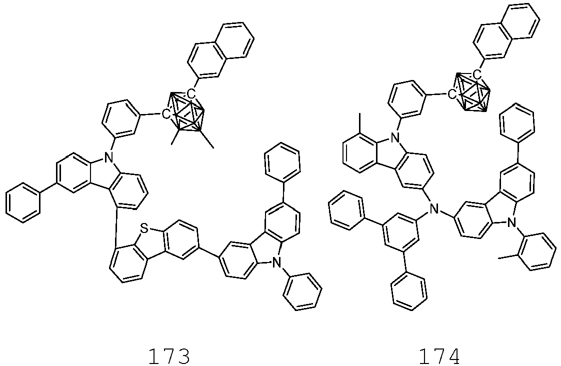

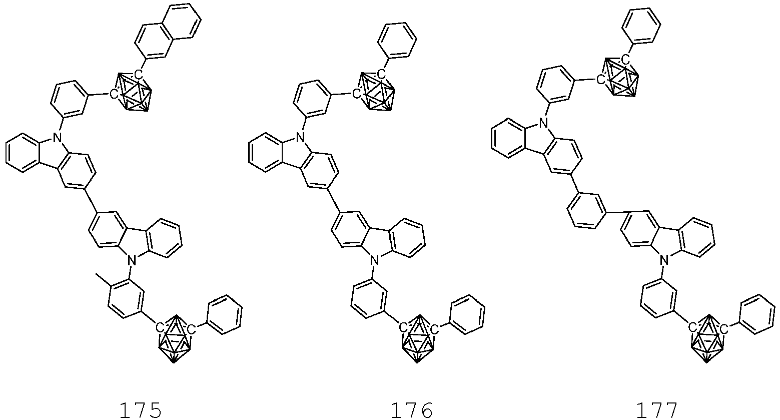

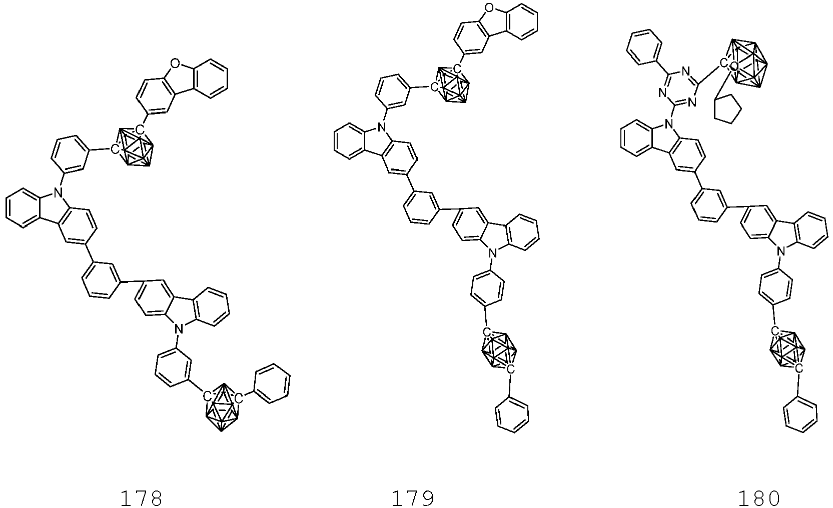

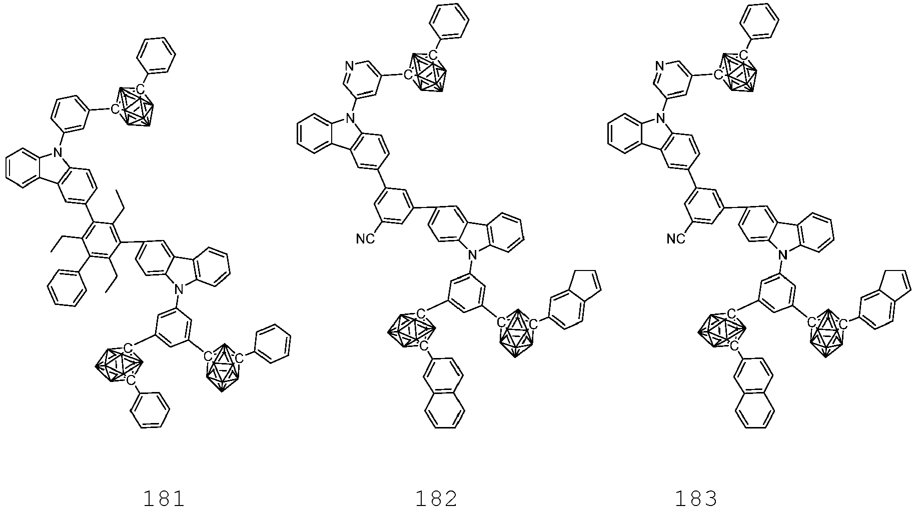

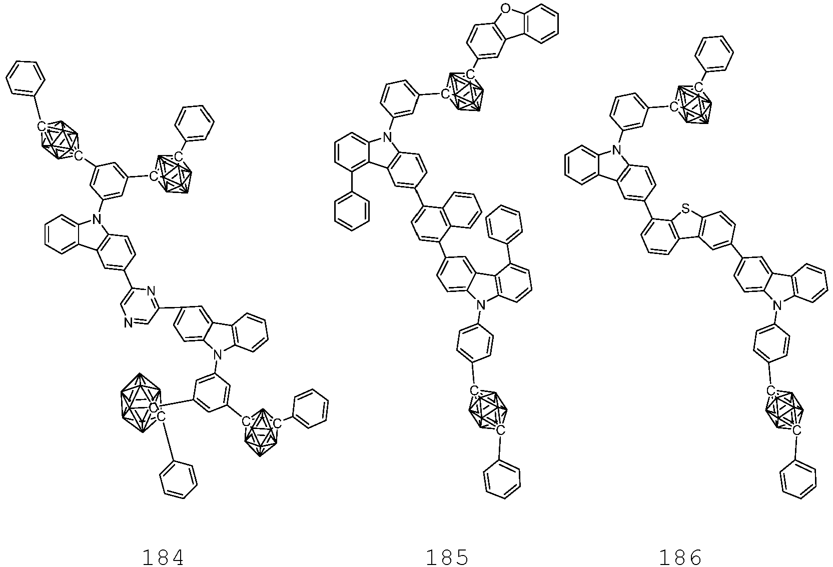

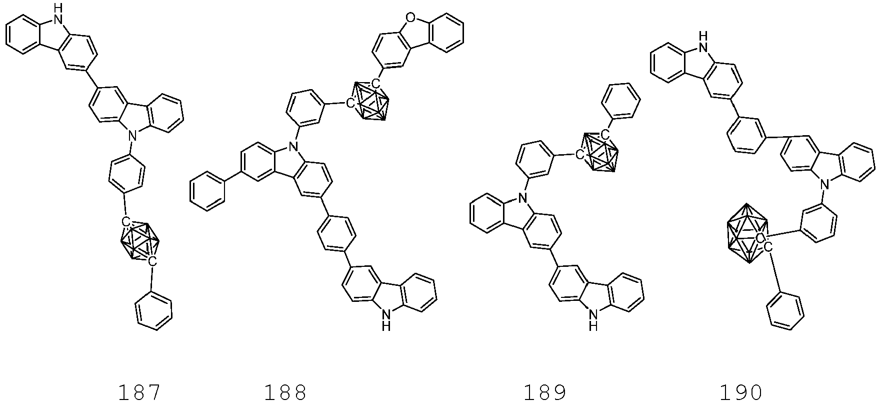

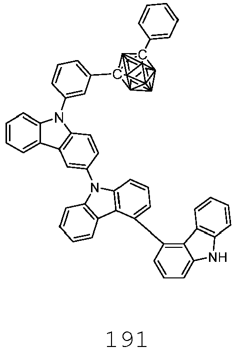

Next, the general formulae (2) and (3) are described. The same symbols in the general formulae (2) and (3) have the same meaning.

In the general formulae (2) and (3), a ring a, a ring c, and a ring c' each represent an aromatic ring (meaning an aromatic hydrocarbon ring, an aromatic heterocycle, or both of the ring and the heterocycle) represented by the formula (a1), which is fused with two adjacent rings at arbitrary positions. Herein, in the formula (a1), X¹, which represents C-R or N, preferably represents C-R.

A ring b, a ring d, and a ring d' each represent a heterocycle represented by the formula (b1), which is fused with two adjacent rings at arbitrary positions. Herein, the ring c and the ring c', or the ring d and the ring d' may be identical to or different from each other.

Although the aromatic ring represented by the formula (a1) can be fused with two adjacent rings at arbitrary positions, the aromatic ring cannot be structurally fused therewith at some positions. Although the aromatic ring represented by the formula (a1) has six sides, the aromatic ring is not fused with the two adjacent rings on two adjacent sides. In addition, although, in the general formulae (2) and (3), the heterocycle represented by the formula (b1) can be fused with two adjacent rings at arbitrary positions, the heterocycle cannot be structurally fused therewith at some positions. That is, although the heterocycle has five sides, the heterocycle is not fused with the two adjacent rings on two adjacent sides. In addition, the heterocycle is not fused with any adjacent ring on a side containing a nitrogen atom. Therefore, the number of kinds of the skeletons of the isomers of the compounds represented by the general formulae (2) and (3) is limited.

Ar¹ and Ar² each independently represent an aromatic hydrocarbon group having 6 to 30 carbon atoms, or an aromatic heterocyclic group having 3 to 16 carbon atoms, preferably an aromatic hydrocarbon group having 6 to 22 carbon atoms, or an aromatic heterocyclic group having 3 to 16 carbon atoms, more preferably an aromatic hydrocarbon group having 6 to 18 carbon atoms, or an aromatic heterocyclic group having 3 to 16 carbon atoms. Those aromatic hydrocarbon groups or aromatic heterocyclic groups may each have a substituent. Ar¹ and Ar² each represent a v+1-valent group.

Specific examples of Ar¹ and Ar² include groups each produced by removing v+1 hydrogen atoms from benzene, pentalene, indene, naphthalene, azulene, heptalene, octalene, indacene, acenaphthylene, phenalene, phenanthrene, anthracene, trindene, fluoranthene, acephenanthrylene, aceanthrylene, triphenylene, pyrene, chrysene, tetraphene, tetracene, pleiadene, picene, perylene, pentaphene, pentacene, tetraphenylene, cholanthrylene, a helicene, hexaphene, rubicene, coronene, trinaphthylene, heptaphene, pyranthrene, furan, benzofuran, isobenzofuran, xanthene, oxanthrene, dibenzofuran, peri-xanthenoxanthene, thiophene, thioxanthene, thianthrene, phenoxathiin, thionaphthene, isothianaphthene, thiophthene, thiophanthrene, dibenzothiophene, pyrrole, pyrazole, tellurazole, selenazole, thiazole, isothiazole, oxazole, furazan, pyridine, pyrazine, pyrimidine, pyridazine, triazine, indolizine, indole, isoindole, indazole, purine, quinolizine, isoquinoline, carbazole, imidazole, naphthyridine, phthalazine, quinazoline, benzodiazepine, quinoxaline, cinnoline, quinoline, pteridine, phenanthridine, acridine, perimidine, phenanthroline, phenazine, carboline, phenotellurazine, phenoselenazine, phenothiazine, phenoxazine, anthyridine, benzothiazole, benzimidazole, benzoxazole, benzisoxazole, or benzisothiazole. The group is preferably, for example, a group produced by removing v+1 hydrogen atoms from benzene, naphthalene, anthracene, pyridine, pyrazine, pyrimidine, pyridazine, triazine, carbazole, dibenzofuran, dibenzothiophene, quinoline, isoquinoline, quinoxaline, or naphthyridine.

L¹ and L² each independently represent an aromatic hydrocarbon group having 6 to 30 carbon atoms, an aromatic heterocyclic group having 3 to 16 carbon atoms, or a linked aromatic group obtained by linking 2 to 10 aromatic rings of the aromatic hydrocarbon group or the aromatic heterocyclic group, preferably an aromatic hydrocarbon group having 6 to 18 carbon atoms, an aromatic heterocyclic group having 3 to 16 carbon atoms, or a linked aromatic group obtained by linking 2 to 7 aromatic rings of the aromatic hydrocarbon group or the aromatic heterocyclic group. The aromatic hydrocarbon group, the aromatic heterocyclic group, and the linked aromatic group may each have a substituent.

Specific examples of L¹ and L² include groups each produced by removing one hydrogen atom from benzene, pentalene, indene, naphthalene, azulene, heptalene, octalene, indacene, acenaphthylene, phenalene, phenanthrene, anthracene, trindene, fluoranthene, acephenanthrylene, aceanthrylene, triphenylene, pyrene, chrysene, tetraphene, tetracene, pleiadene, picene, perylene, pentaphene, pentacene, tetraphenylene, cholanthrylene, a helicene, hexaphene, rubicene, coronene, trinaphthylene, heptaphene, pyranthrene, furan, benzofuran, isobenzofuran, xanthene, oxanthrene, dibenzofuran, peri-xanthenoxanthene, thiophene, thioxanthene, thianthrene, phenoxathiin, thionaphthene, isothianaphthene, thiophthene, thiophanthrene, dibenzothiophene, pyrrole, pyrazole, tellurazole, selenazole, thiazole, isothiazole, oxazole, furazan, pyridine, pyrazine, pyrimidine, pyridazine, triazine, indolizine, indole, isoindole, indazole, purine, quinolizine, isoquinoline, carbazole, imidazole, naphthyridine, phthalazine, quinazoline, benzodiazepine, quinoxaline, cinnoline, quinoline, pteridine, phenanthridine, acridine, perimidine, phenanthroline, phenazine, carboline, phenotellurazine, phenoselenazine, phenothiazine, phenoxazine, anthyridine, benzothiazole, benzimidazole, benzoxazole, benzisoxazole, or benzisothiazole, or an aromatic compound in which a plurality of aromatic rings of these aromatic compounds are linked to each other.

In the general formula (3), Z represents a divalent aromatic hydrocarbon group having 6 to 30 carbon atoms, a divalent aromatic heterocyclic group having 3 to 16 carbon atoms, or a divalent linked aromatic group obtained by linking 2 to 10 aromatic rings of the aromatic hydrocarbon group or the aromatic heterocyclic group, preferably an aromatic hydrocarbon group having 6 to 18 carbon atoms, an aromatic heterocyclic group having 3 to 16 carbon atoms, or a linked aromatic group obtained by linking 2 to 7 aromatic rings of the aromatic hydrocarbon group or the aromatic heterocyclic group. The respective aromatic rings may each independently have a substituent.

Specific examples of Z include divalent groups each produced by removing two hydrogen atoms from an aromatic compound listed in the specific examples of L¹ and L², or a linked aromatic compound in which a plurality of such compounds are linked to each other.

In the general formula (2) and the formula (b1), vs each independently represent an integer of from 0 to 7, preferably from 0 to 5, more preferably from 0 to 3.

R⁶ to R¹² each independently represent hydrogen, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 30 carbon atoms, or an aromatic heterocyclic group having 3 to 30 carbon atoms, preferably hydrogen, an alkyl group having 1 to 10 carbon atoms, an aralkyl group having 7 to 24 carbon atoms, an alkoxy group having 1 to 10 carbon atoms, a diarylamino group having 12 to 36 carbon atoms, an aromatic hydrocarbon group having 6 to 18 carbon atoms, or an aromatic heterocyclic group having 3 to 16 carbon atoms. In the case of the groups except hydrogen, the groups may each have a substituent. In addition, when any one of R⁶ to R¹² represents a phenyl group, the phenyl group may form a fused ring with an aromatic ring substituted with the phenyl group.

Specific examples of the alkyl group having 1 to 20 carbon atoms, the aralkyl group having 7 to 38 carbon atoms, the alkenyl group having 2 to 20 carbon atoms, the alkynyl group having 2 to 20 carbon atoms, the dialkylamino group having 2 to 40 carbon atoms, the diarylamino group having 12 to 44 carbon atoms, the diaralkylamino group having 14 to 76 carbon atoms, the acyl group having 2 to 20 carbon atoms, the acyloxy group having 2 to 20 carbon atoms, the alkoxy group having 1 to 20 carbon atoms, the alkoxycarbonyl group having 2 to 20 carbon atoms, the alkoxycarbonyloxy group having 2 to 20 carbon atoms, or the alkylsulfonyl group having 1 to 20 carbon atoms include methyl, ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, icosyl, phenylmethyl, phenylethyl, phenylicosyl, naphthylmethyl, anthranylmethyl, phenanthrenylmethyl, pyrenylmethyl, vinyl, propenyl, butenyl, pentenyl, decenyl, icosenyl, ethynyl, propargyl, butynyl, pentynyl, decynyl, icosynyl, dimethylamino, ethylmethylamino, diethylamino, dipropylamino, dibutylamino, dipentynylamino, didecylamino, diicosylamino, diphenylamino, naphthylphenylamino, dinaphthylamino, dianthranylamino, diphenanthrenylamino, dipyrenylamino, diphenylmethylamino, diphenylethylamino, phenylmethylphenylethylamino, dinaphthylmethylamino, dianthranylmethylamino, diphenanthrenylmethylamino, acetyl, propionyl, butyryl, valeryl, benzoyl, acetyloxy, propionyloxy, butyryloxy, valeryloxy, benzoyloxy, methoxy, ethoxy, propoxy, butoxy, pentoxy, hexoxy, heptoxy, octoxy, nonyloxy, detoxy, undecyloxy, dodetoxy, tridetoxy, tetradetoxy, pentadetoxy, hexadetoxy, heptadetoxy, octadetoxy, nonadetoxy, icoxy, methoxycarbonyl, ethoxycarbonyl, propoxycarbonyl, butoxycarbonyl, pentoxycarbonyl, methoxycarbonyloxy, ethoxycarbonyloxy, propoxycarbonyloxy, butoxycarbonyloxy, pentoxycarbonyloxy, methylsulfonyl, ethylsulfonyl, propylsulfonyl, butylsulfonyl, and pentylsulfonyl. The group is preferably, for example, an alkyl group having 1 to 10 carbon atoms, such as methyl, ethyl, propyl, butyl, pentyl, hexyl, heptyl, octyl, nonyl, or decyl, an aralkyl group having 7 to 17 carbon atoms, such as phenylmethyl, phenylethyl, naphthylmethyl, anthranylmethyl, phenanthrenylmethyl, or pyrenylmethyl, an alkoxy group having 1 to 10 carbon atoms, such as methoxy, ethoxy, propoxy, butoxy, pentoxy, hexoxy, heptoxy, octoxy, nonyloxy, or detoxy, or a diarylamino group having 12 to 28 carbon atoms, such as diphenylamino, naphthylphenylamino, dinaphthylamino, dianthranylamino, or diphenanthrenylamino.

Specific examples of the aromatic hydrocarbon group having 6 to 30 carbon atoms or the aromatic heterocyclic group having 3 to 16 carbon atoms include groups each produced by removing a hydrogen atom from benzene, pentalene, indene, naphthalene, azulene, indacene, acenaphthylene, phenalene, phenanthrene, anthracene, trindene, fluoranthene, acephenanthrylene, aceanthrylene, triphenylene, pyrene, chrysene, tetraphene, tetracene, pleiadene, picene, perylene, pentaphene, pentacene, tetraphenylene, cholanthrylene, furan, benzofuran, isobenzofuran, xanthene, oxanthrene, dibenzofuran, peri-xanthenoxanthene, thiophene, thioxanthene, thianthrene, phenoxathiin, thionaphthene, isothianaphthene, thiophthene, thiophanthrene, dibenzothiophene, pyrrole, pyrazole, tellurazole, selenazole, thiazole, isothiazole, oxazole, furazan, thiadiazole, pyridine, pyrazine, pyrimidine, pyridazine, triazine, indolizine, indole, isoindole, indazole, purine, quinolizine, isoquinoline, carbazole, imidazole, naphthyridine, phthalazine, quinazoline, benzodiazepine, quinoxaline, cinnoline, quinoline, pteridine, phenanthridine, acridine, perimidine, phenanthroline, phenazine, carboline, phenotellurazine, phenoselenazine, phenothiazine, phenoxazine, anthyridine, benzothiazole, benzimidazole, benzoxazole, benzisoxazole, or benzisothiazole. The group is preferably, for example, a group produced by removing a hydrogen atom from benzene, naphthalene, anthracene, pyridine, pyrazine, pyrimidine, pyridazine, triazine, isoindole, indazole, purine, isoquinoline, imidazole, naphthyridine, phthalazine, quinazoline, benzodiazepine, quinoxaline, cinnoline, quinoline, pteridine, phenanthridine, acridine, perimidine, phenanthroline, phenazine, carboline, indole, carbazole, dibenzofuran, or dibenzothiophene.

In the case where Ar¹, Ar², Z, L¹, and L² each represent an aromatic hydrocarbon group, an aromatic heterocyclic group, or a linked aromatic group obtained by linking these groups, the group may have a substituent. In this case, the substituent is an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, or an alkylsulfonyl group having 1 to 20 carbon atoms, preferably an alkyl group having 1 to 10 carbon atoms, an aralkyl group having 7 to 24 carbon atoms, an alkoxy group having 1 to 10 carbon atoms, or a diarylamino group having 12 to 36 carbon atoms. The number of the substituents is from 0 to 5, preferably from 0 to 2.

Specific examples of the substituent include methyl, ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, icosyl, phenylmethyl, phenylethyl, phenylicosyl, naphthylmethyl, anthranylmethyl, phenanthrenylmethyl, pyrenylmethyl, vinyl, propenyl, butenyl, pentenyl, decenyl, icosenyl, ethynyl, propargyl, butynyl, pentynyl, decynyl, icosynyl, dimethylamino, ethylmethylamino, diethylamino, dipropylamino, dibutylamino, dipentynylamino, didecylamino, diicosylamino, diphenylamino, naphthylphenylamino, dinaphthylamino, dianthranylamino, diphenanthrenylamino, dipyrenylamino, diphenylmethylamino, diphenylethylamino, phenylmethylphenylethylamino, dinaphthylmethylamino, dianthranylmethylamino, diphenanthrenylmethylamino, acetyl, propionyl, butyryl, valeryl, benzoyl, acetyloxy, propionyloxy, butyryloxy, valeryloxy, benzoyloxy, methoxy, ethoxy, propoxy, butoxy, pentoxy, hexoxy, heptoxy, octoxy, nonyloxy, detoxy, undecyloxy, dodetoxy, tridetoxy, tetradetoxy, pentadetoxy, hexadetoxy, heptadetoxy, octadetoxy, nonadetoxy, icoxy, methoxycarbonyl, ethoxycarbonyl, propoxycarbonyl, butoxycarbonyl, pentoxycarbonyl, methoxycarbonyloxy, ethoxycarbonyloxy, propoxycarbonyloxy, butoxycarbonyloxy, pentoxycarbonyloxy, methylsulfonyl, ethylsulfonyl, propylsulfonyl, butylsulfonyl, and pentylsulfonyl. The substituent is preferably, for example, a C1 to C12 alkyl group, such as methyl, ethyl, propyl, butyl, pentyl, hexyl, heptyl, octyl, nonyl, or decyl, a C7 to C20 aralkyl group, such as phenylmethyl, phenylethyl, naphthylmethyl, anthranylmethyl, phenanthrenylmethyl, or pyrenylmethyl, a C1 to C10 alkoxy group, such as methoxy, ethoxy, propoxy, butoxy, pentoxy, hexoxy, heptoxy, octoxy, nonyloxy, or detoxy, or a diarylamino group having two C6 to C15 aromatic hydrocarbon groups, such as diphenylamino, naphthylphenylamino, dinaphthylamino, dianthranylamino, or diphenanthrenylamino.

When R⁶ to R¹² each represent a group except hydrogen, and the group has a substituent, the substituent is an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 30 carbon atoms, or an aromatic heterocyclic group having 3 to 30 carbon atoms, preferably an alkyl group having 1 to 10 carbon atoms, an aralkyl group having 7 to 24 carbon atoms, an alkoxy group having 1 to 10 carbon atoms, a diarylamino group having 12 to 36 carbon atoms, an aromatic hydrocarbon group having 6 to 18 carbon atoms, or an aromatic heterocyclic group having 3 to 16 carbon atoms, more preferably an aromatic hydrocarbon group having 6 to 18 carbon atoms or an aromatic heterocyclic group having 3 to 16 carbon atoms.

Specific examples of the alkyl group having 1 to 20 carbon atoms, the aralkyl group having 7 to 38 carbon atoms, the alkenyl group having 2 to 20 carbon atoms, the alkynyl group having 2 to 20 carbon atoms, the dialkylamino group having 2 to 40 carbon atoms, the diarylamino group having 12 to 44 carbon atoms, the diaralkylamino group having 14 to 76 carbon atoms, the acyl group having 2 to 20 carbon atoms, the acyloxy group having 2 to 20 carbon atoms, the alkoxy group having 1 to 20 carbon atoms, the alkoxycarbonyl group having 2 to 20 carbon atoms, the alkoxycarbonyloxy group having 2 to 20 carbon atoms, the alkylsulfonyl group having 1 to 20 carbon atoms, the aromatic hydrocarbon group having 6 to 30 carbon atoms, and the aromatic heterocyclic group having 3 to 16 carbon atoms are same as those having the same number of carbon atoms in the specific examples of R⁶ to R¹² described in the foregoing.

Each of the compounds represented by the general formulae (2) and (3) may be selected from compounds described in, for example, the above-mentioned patent literatures, WO 2008/056746 A1, WO 2011/099374 A1, and WO 2011/080972 A1, or may be synthesized by a synthesis method described in each of the literatures.

Preferred specific examples of the compounds represented by the general formulae (2) and (3) are shown below, but the compounds are not limited thereto.

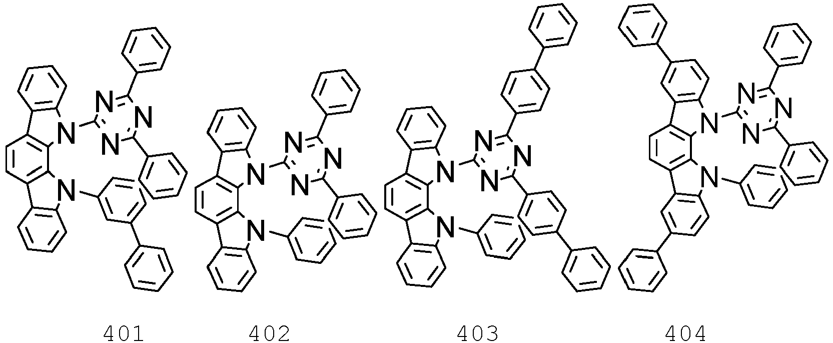

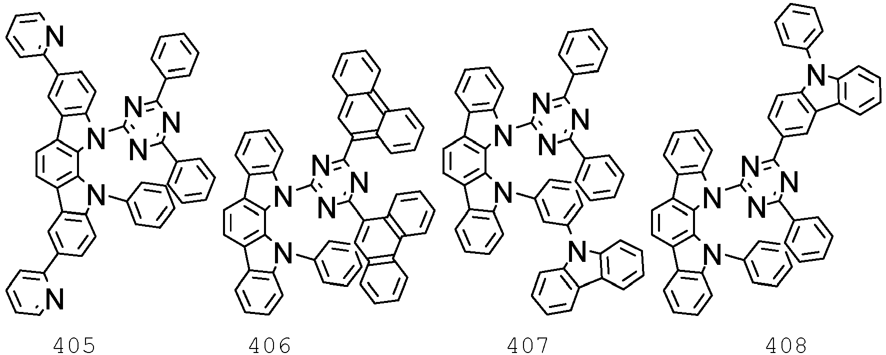

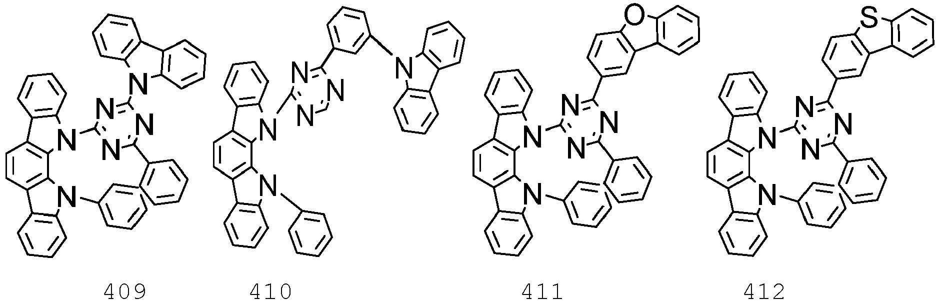

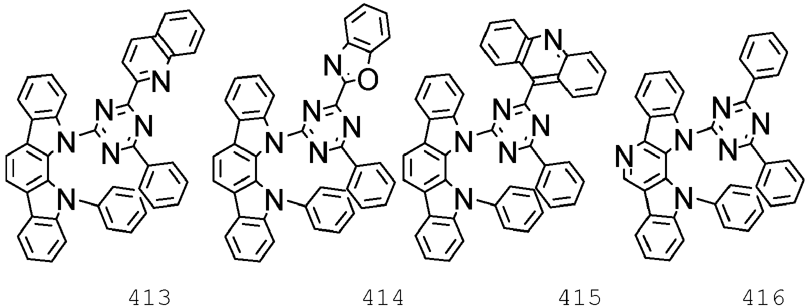

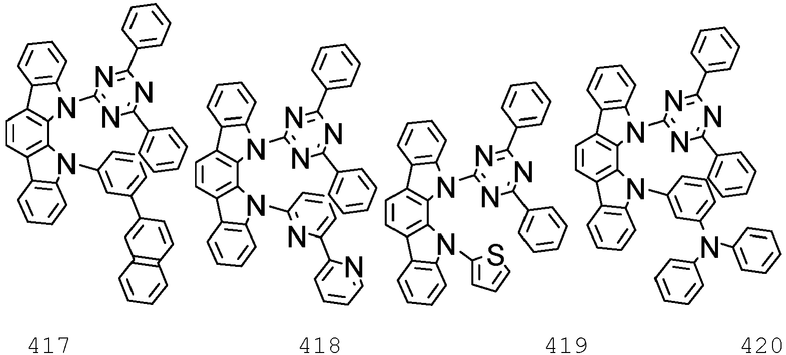

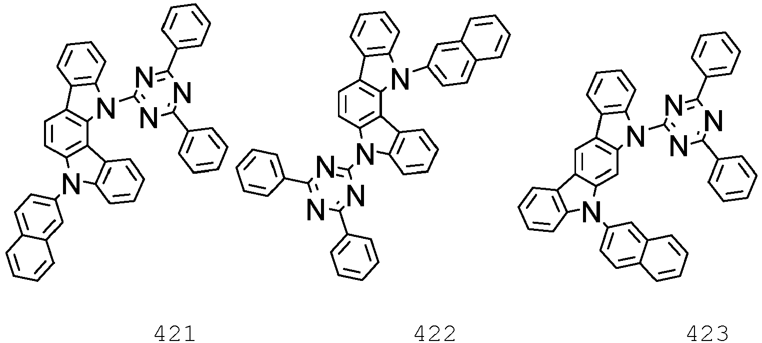

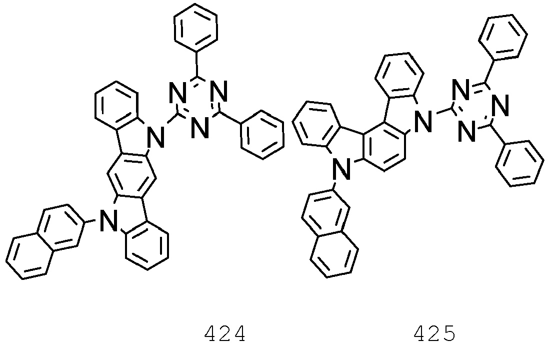

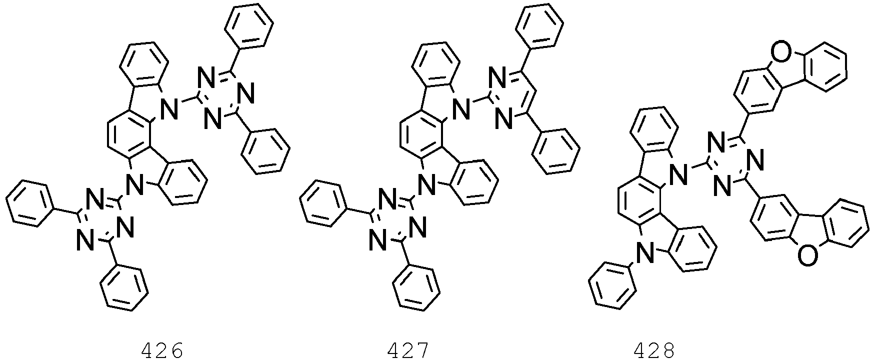

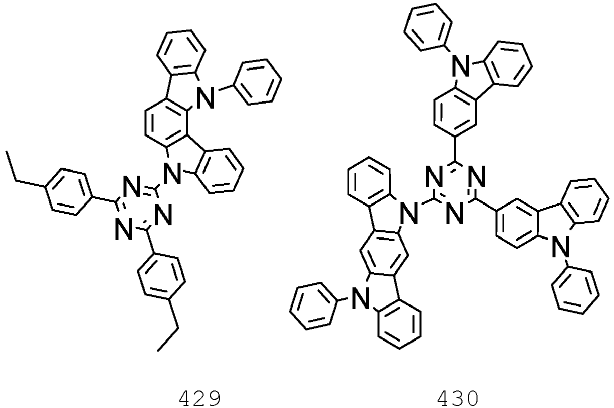

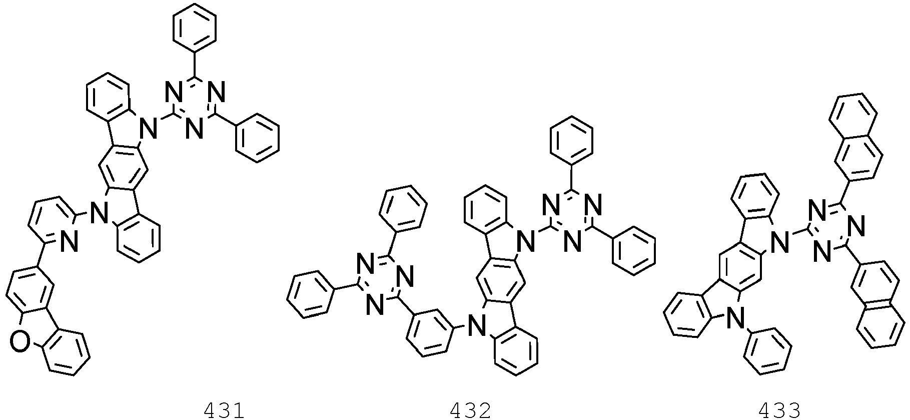

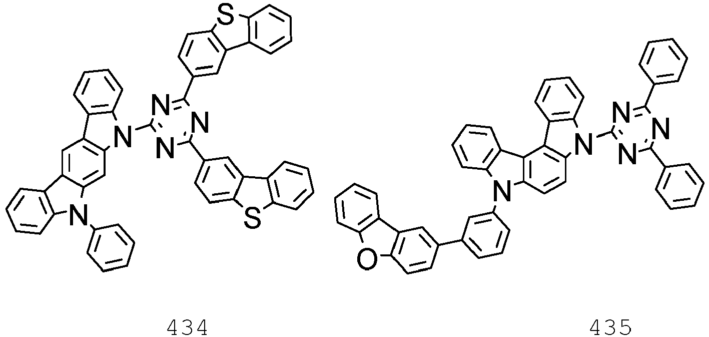

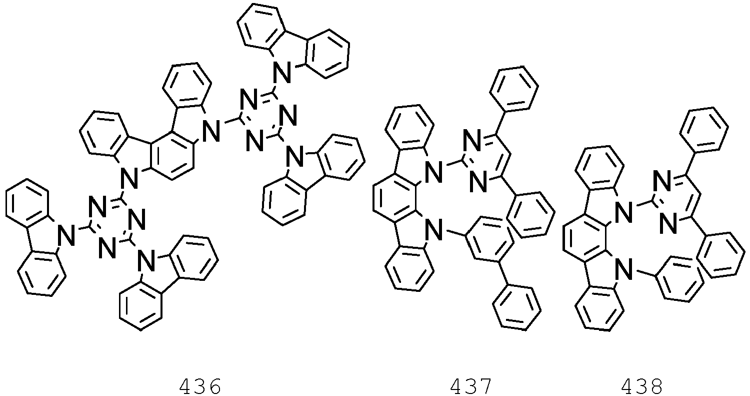

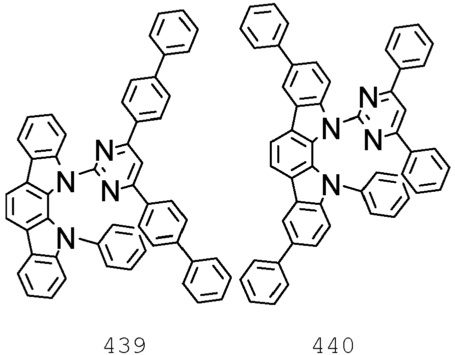

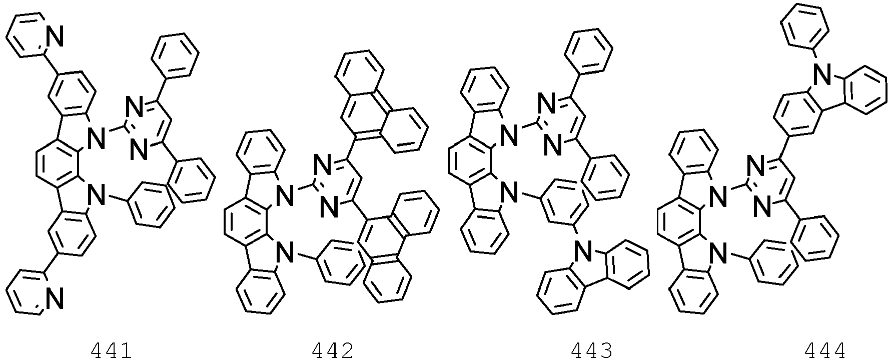

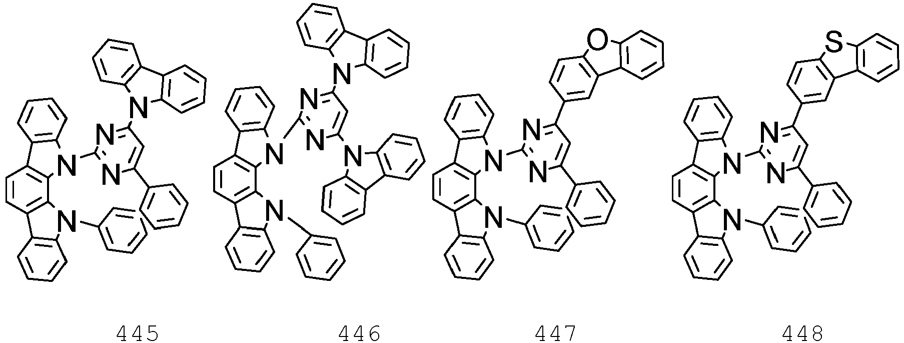

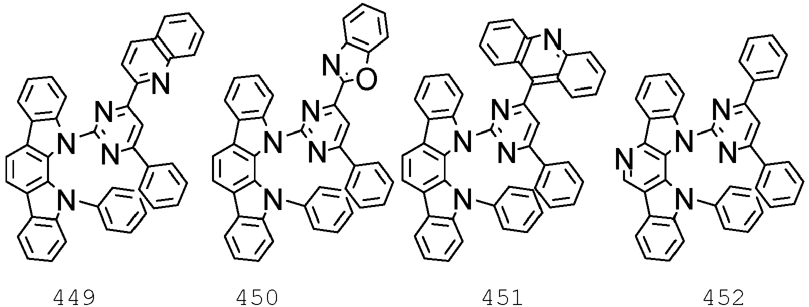

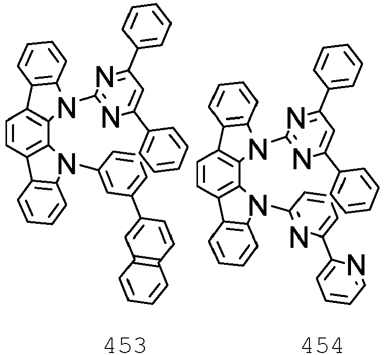

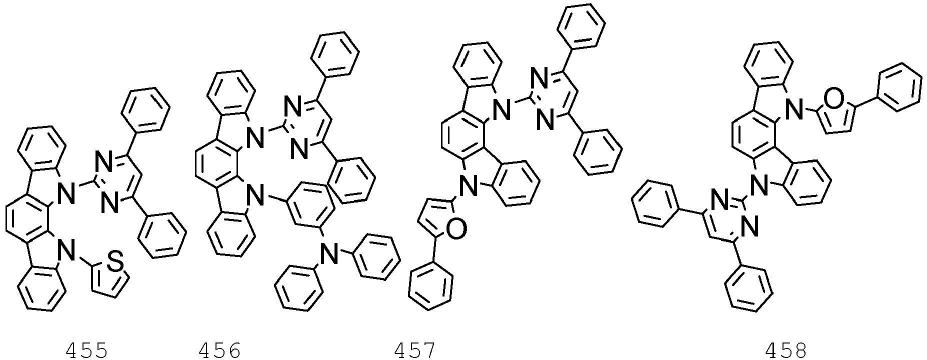

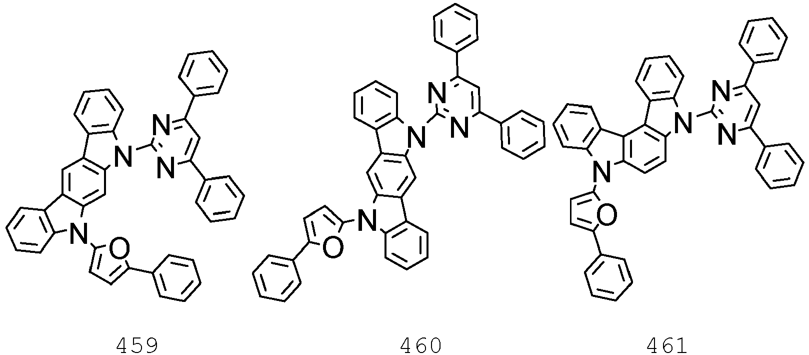

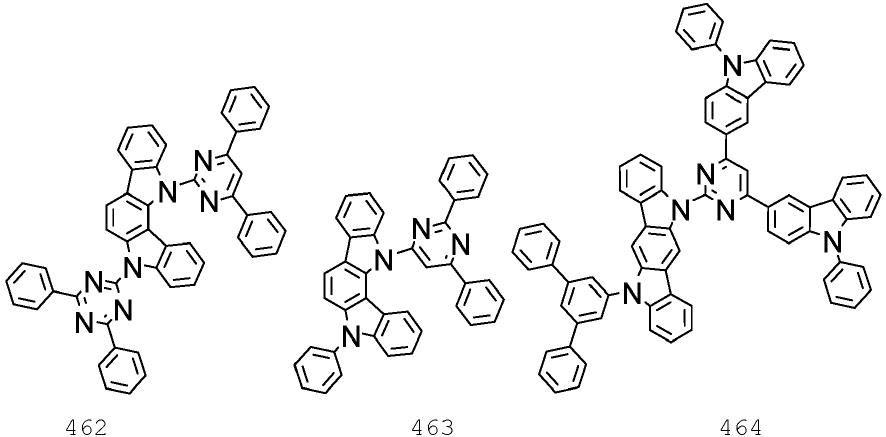

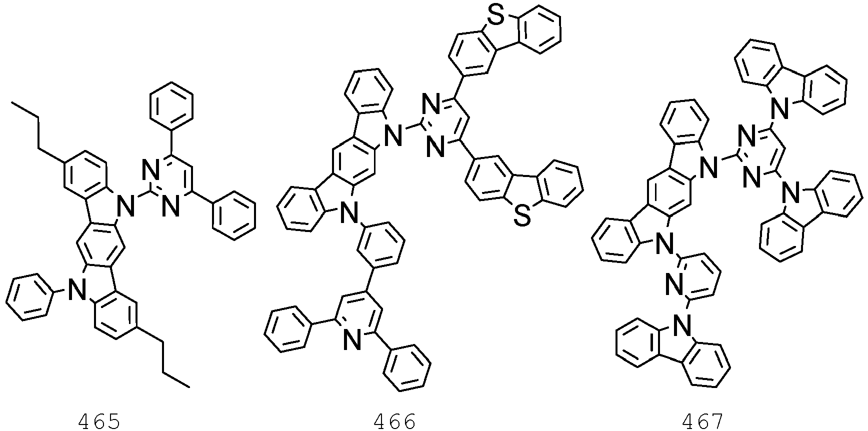

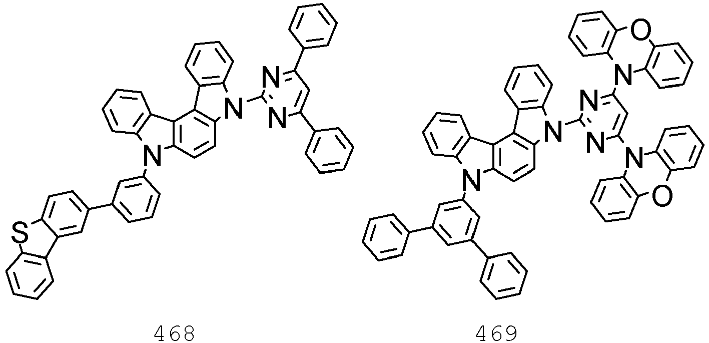

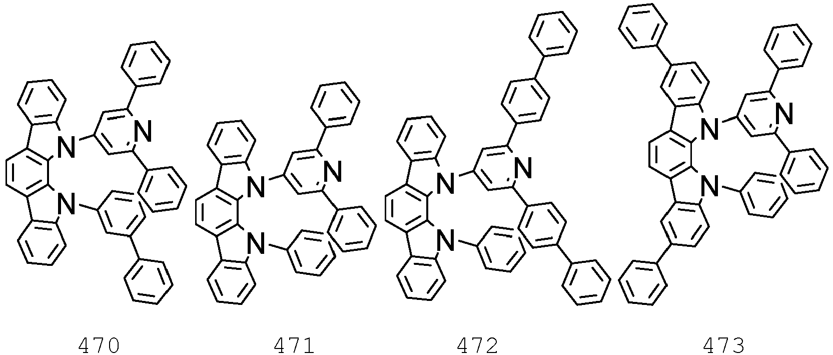

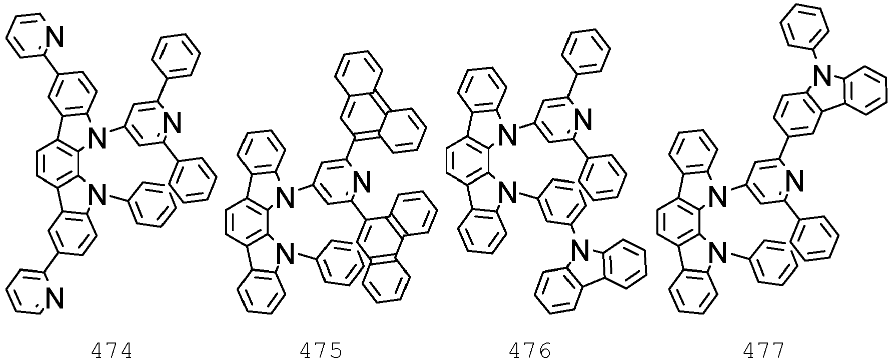

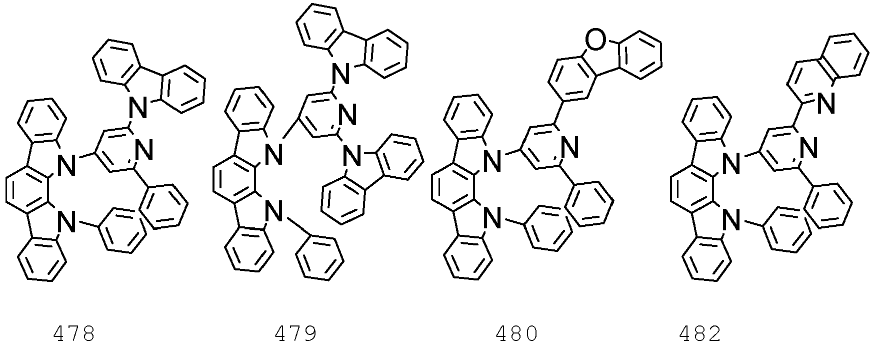

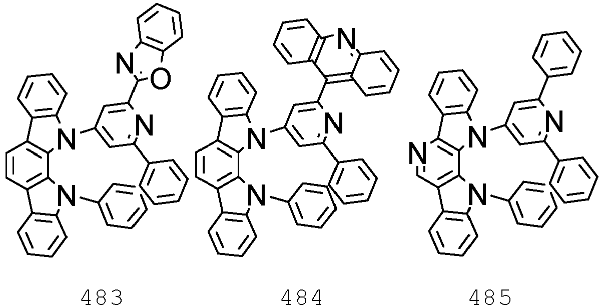

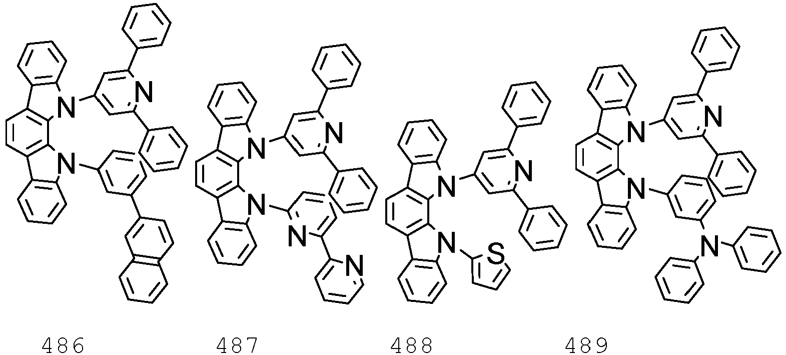

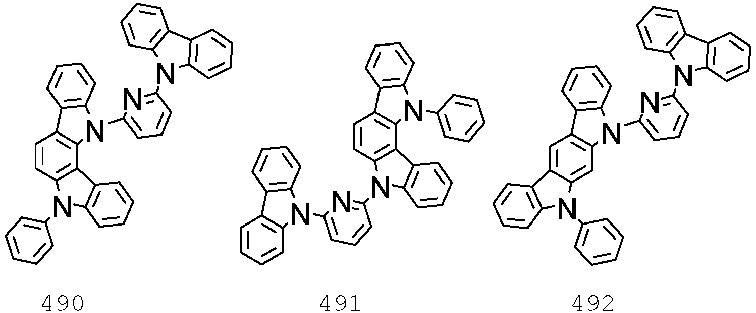

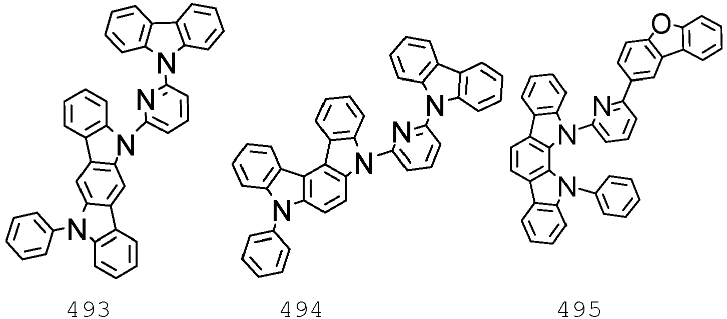

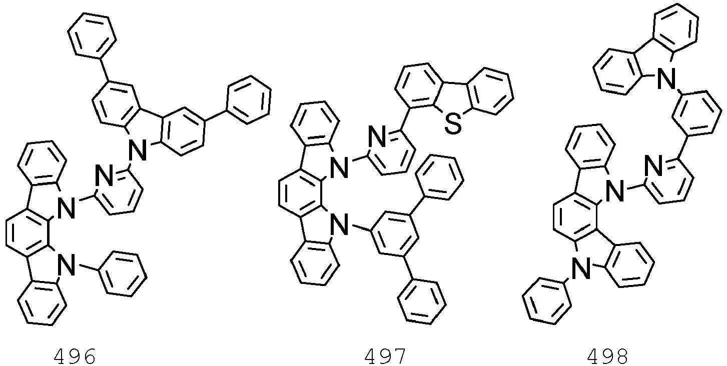

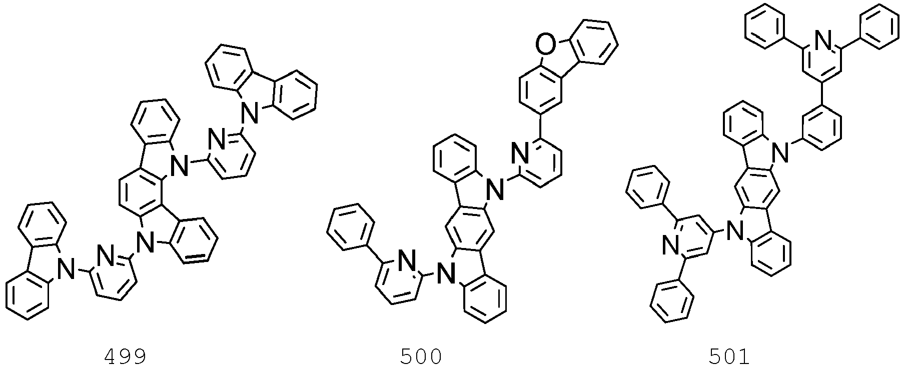

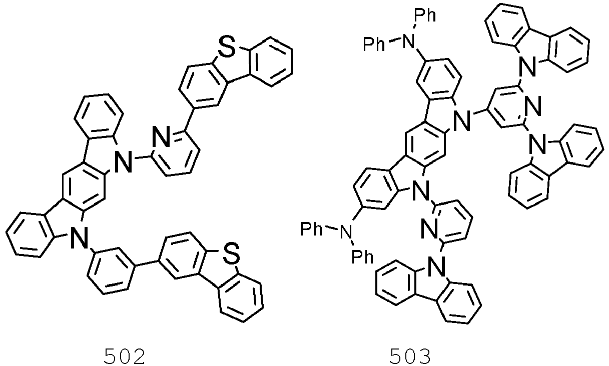

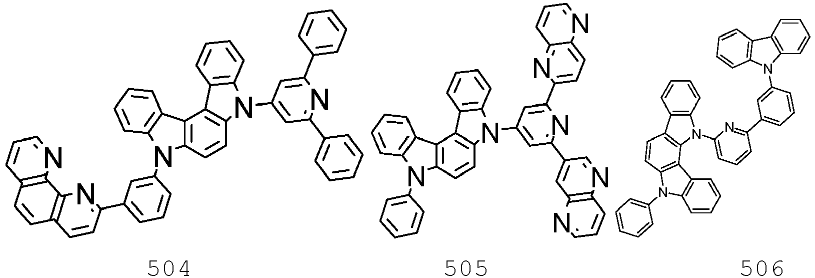

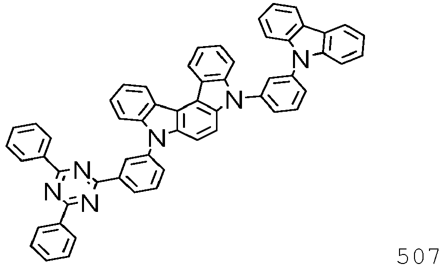

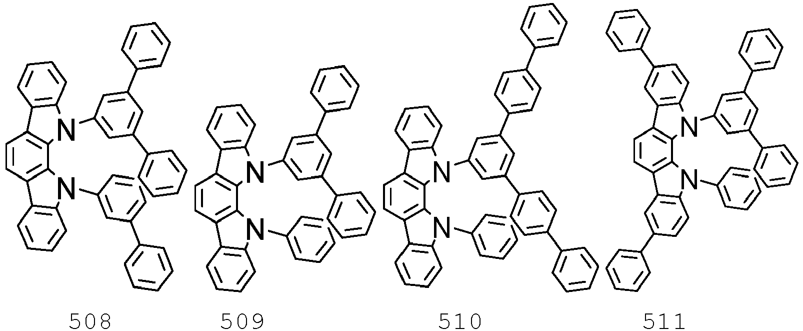

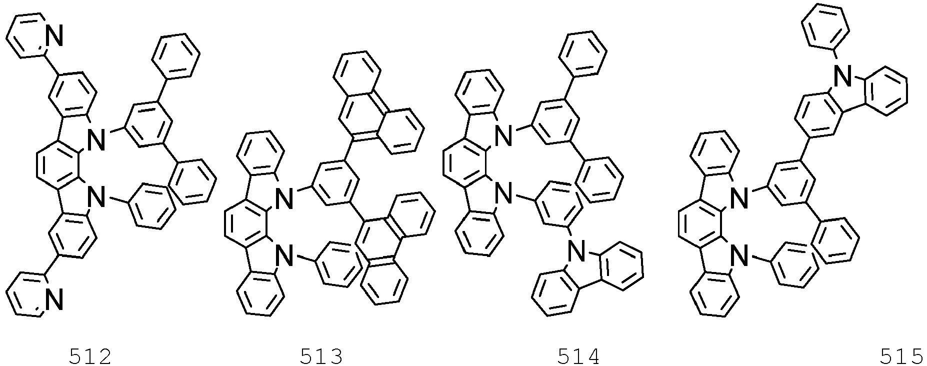

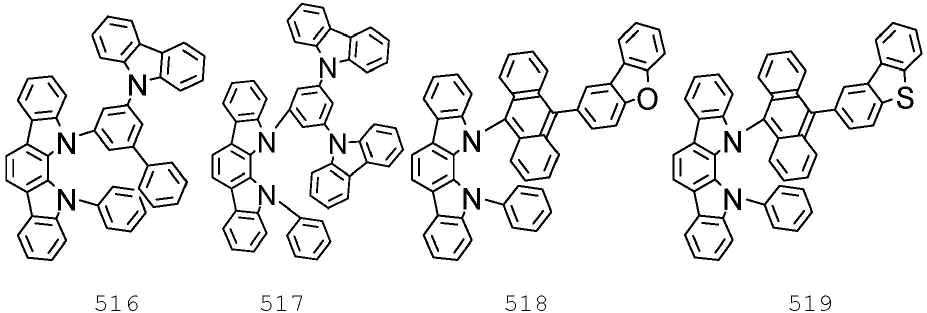

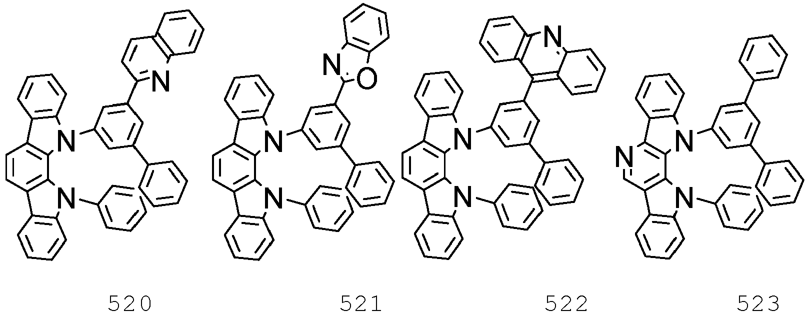

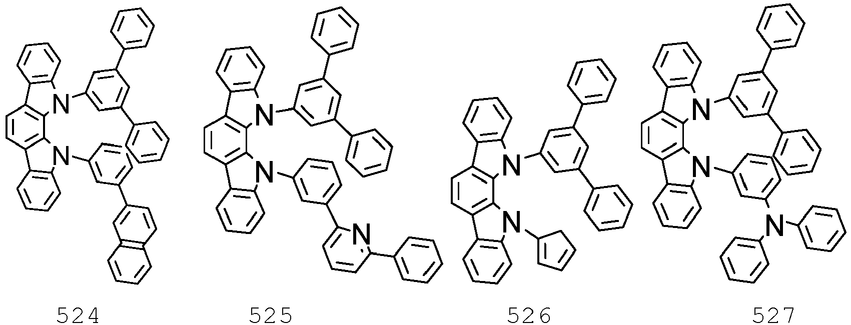

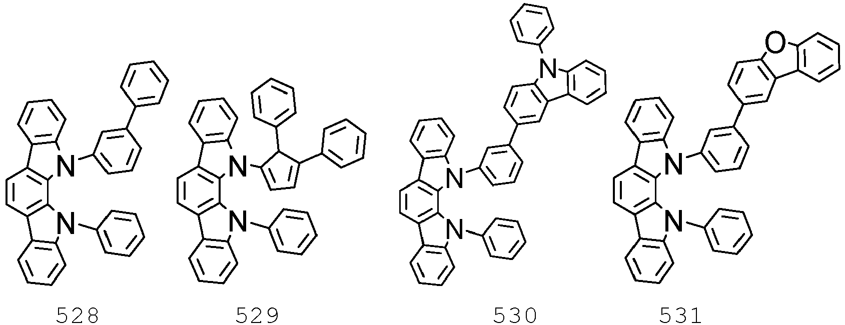

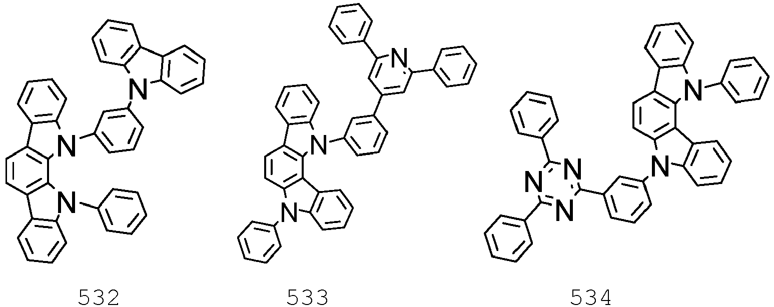

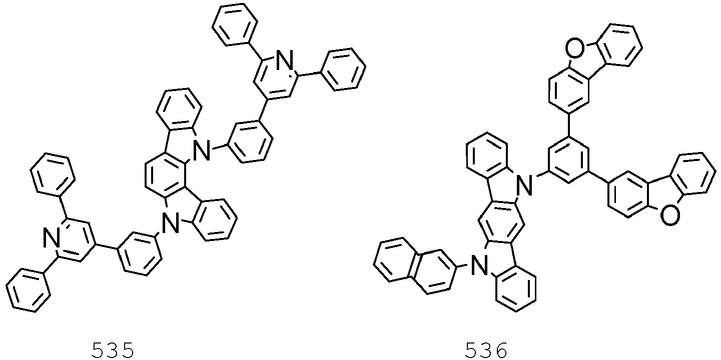

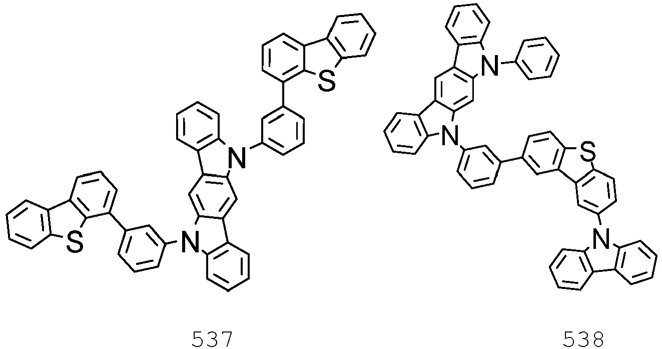

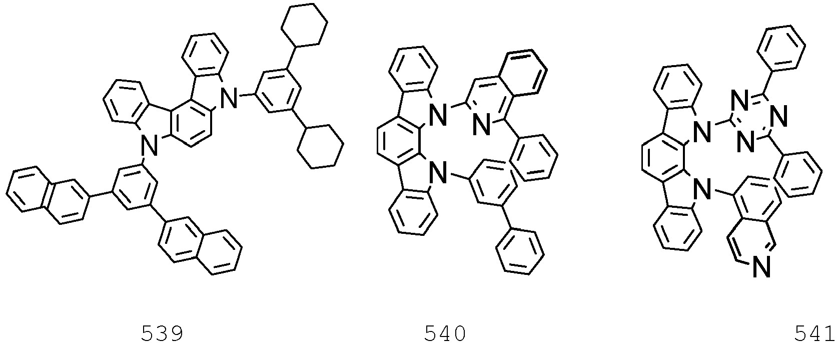

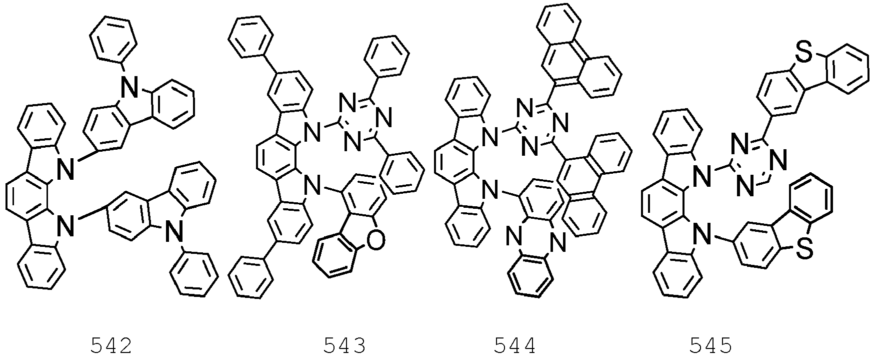

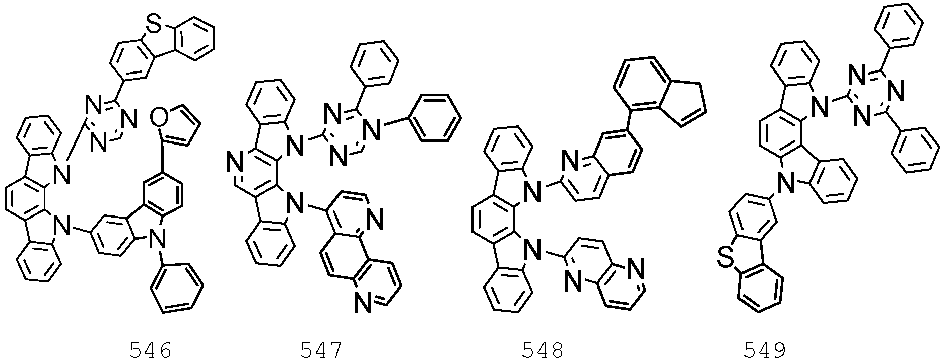

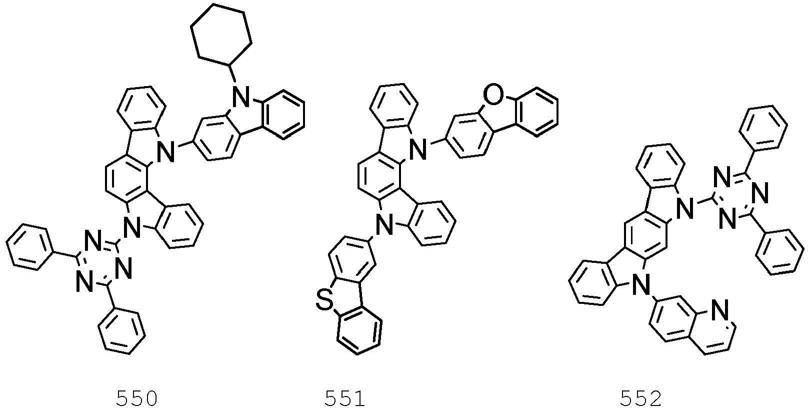

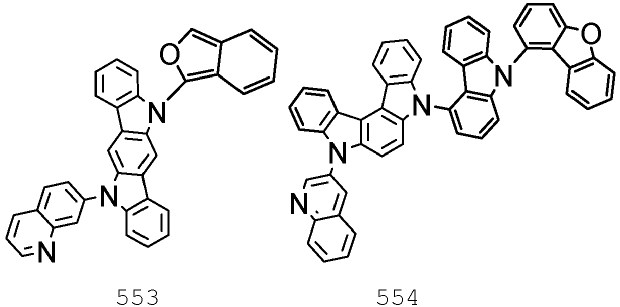

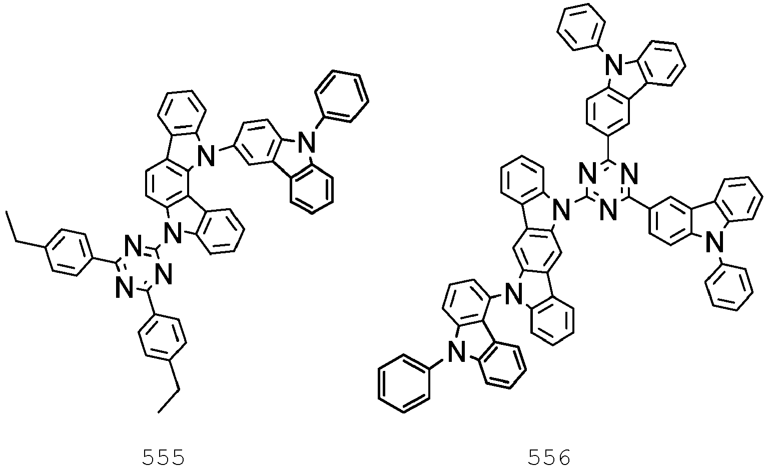

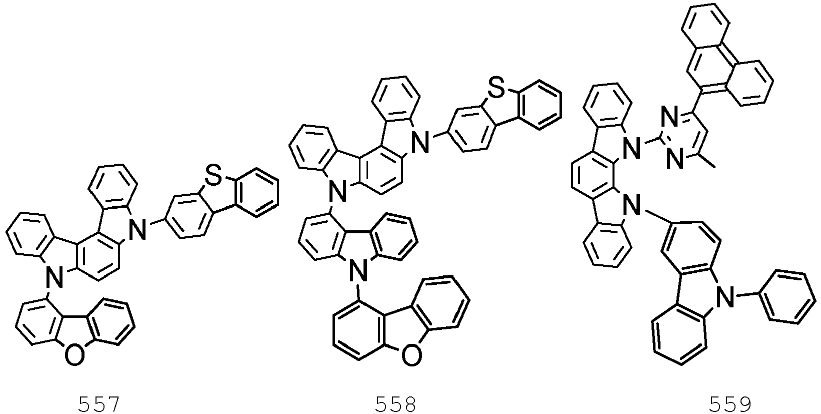

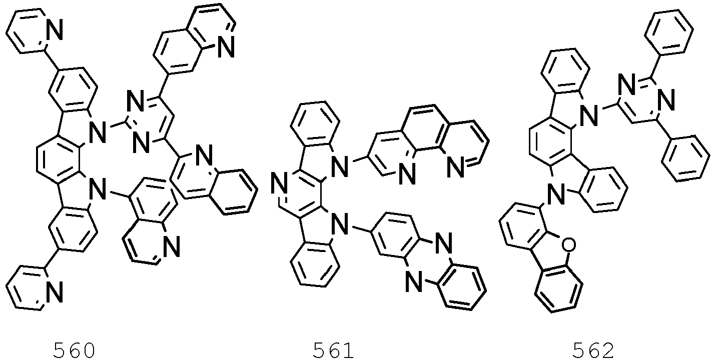

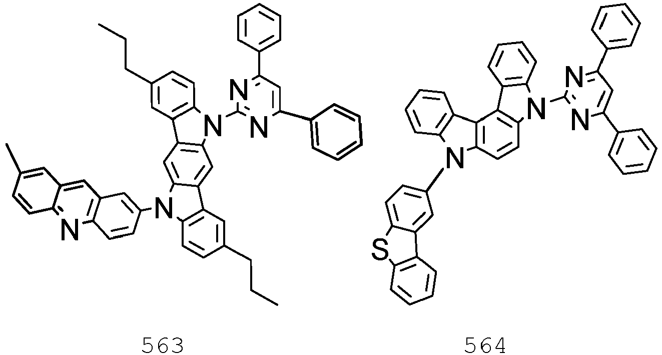

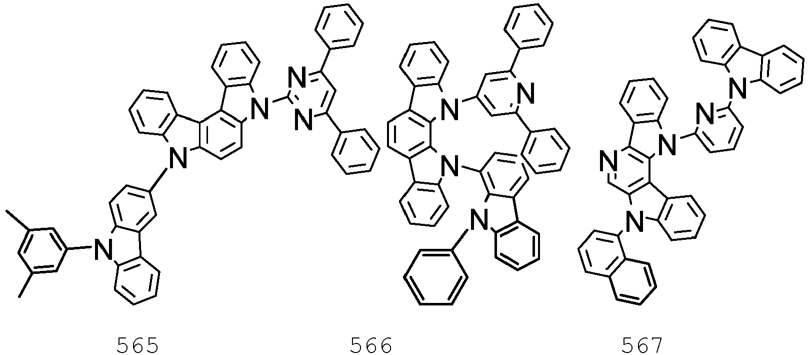

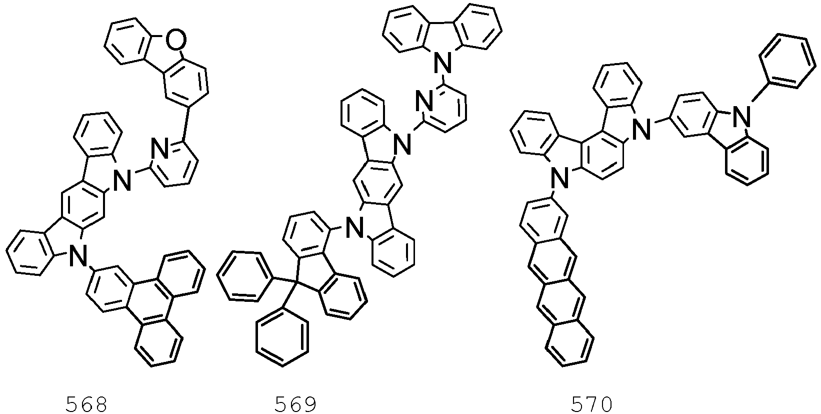

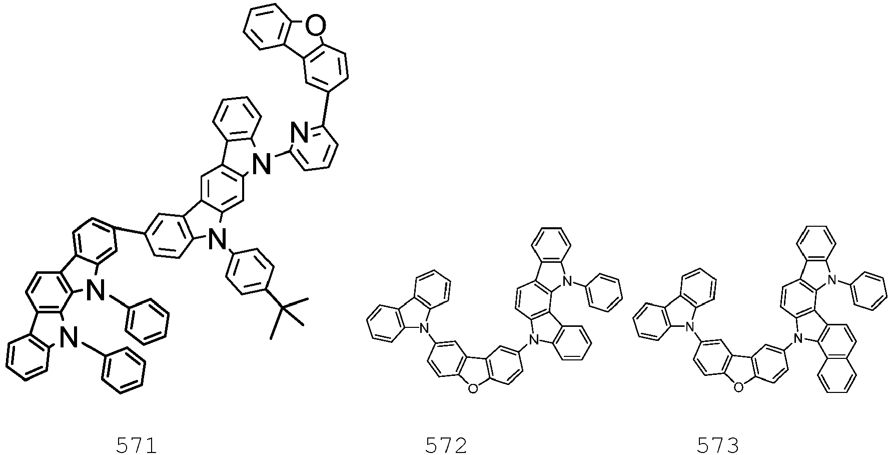

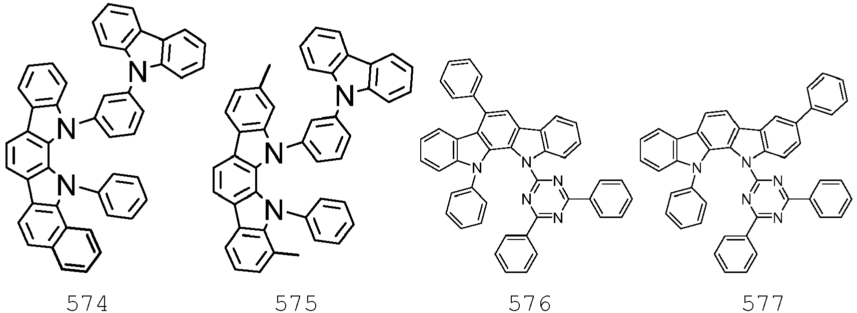

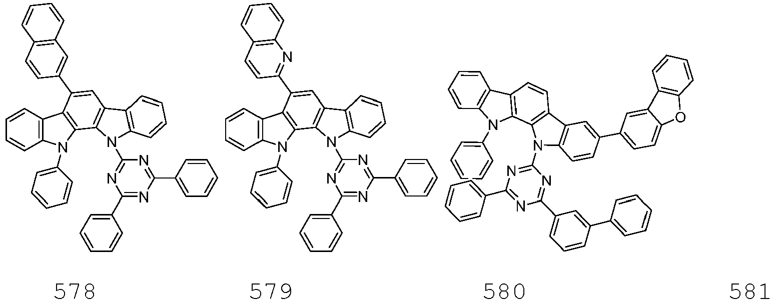

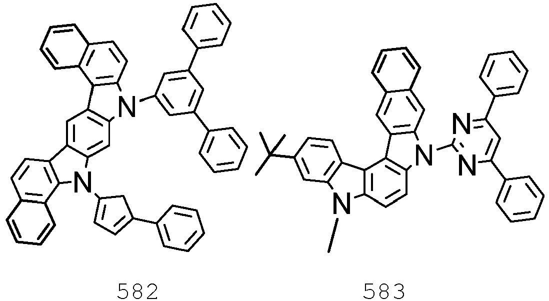

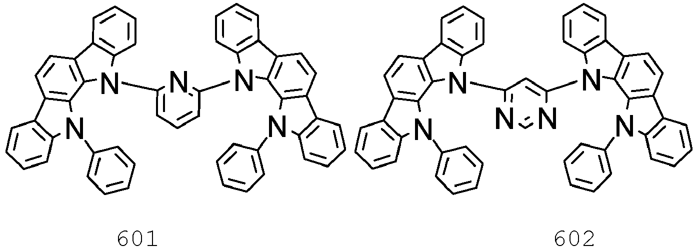

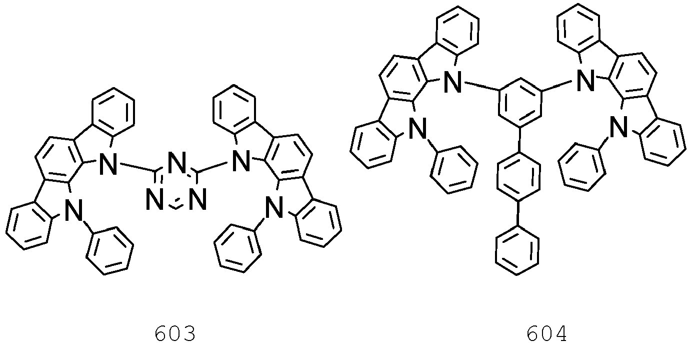

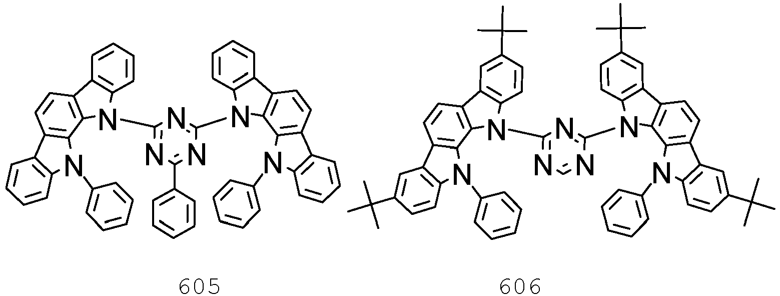

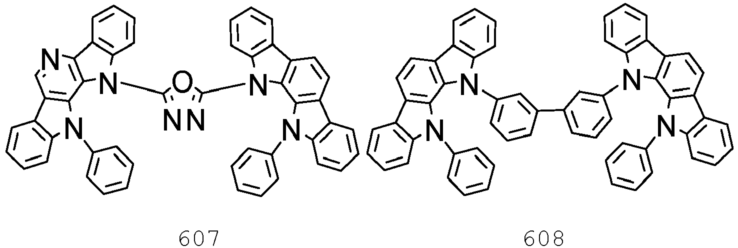

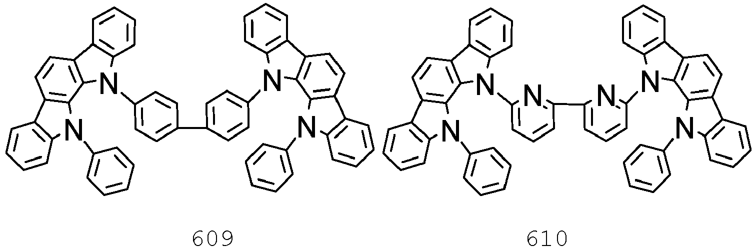

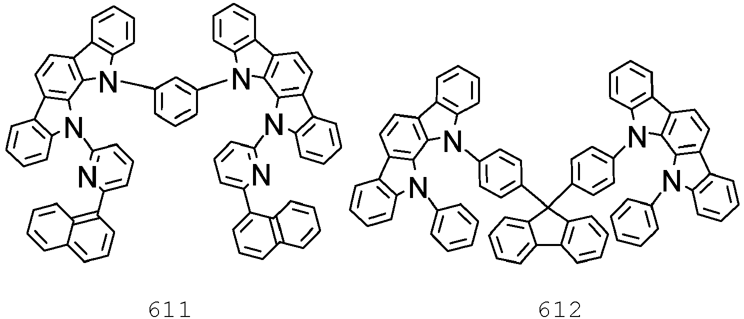

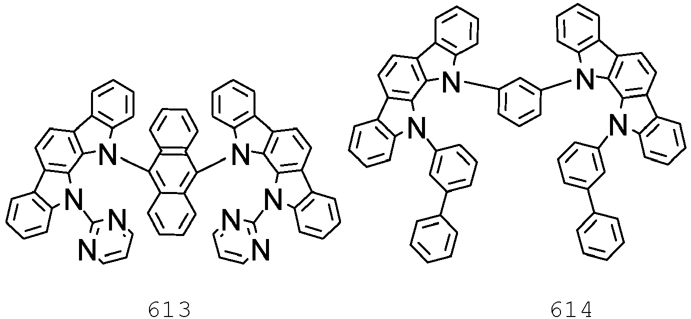

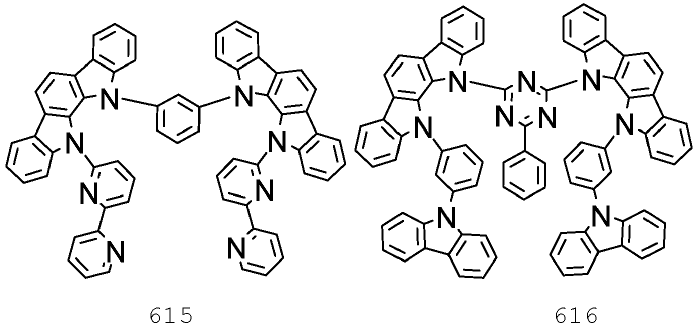

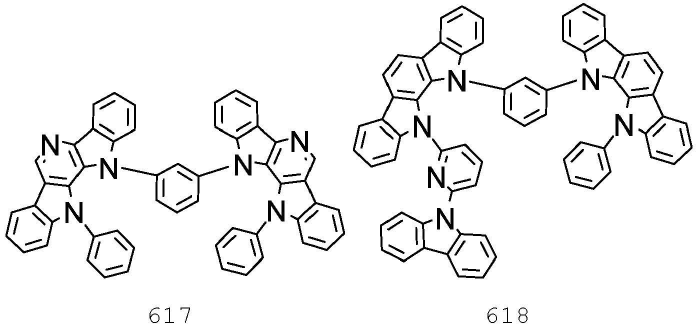

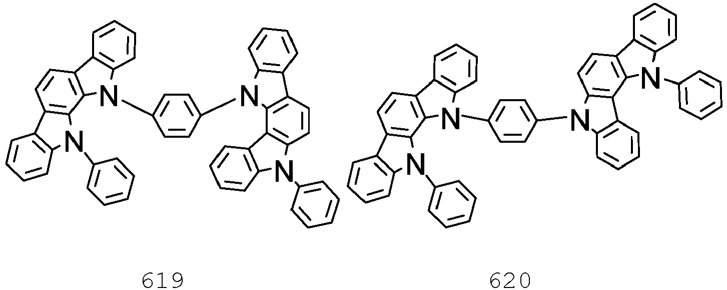

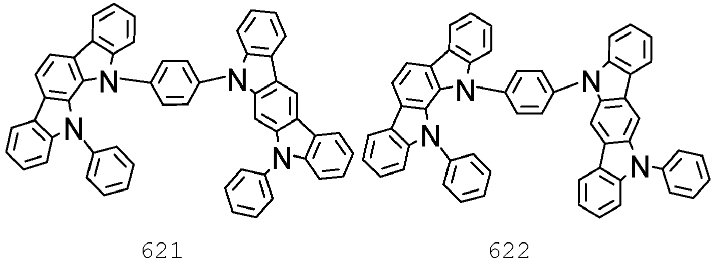

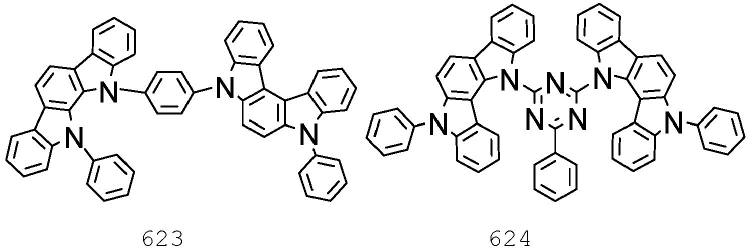

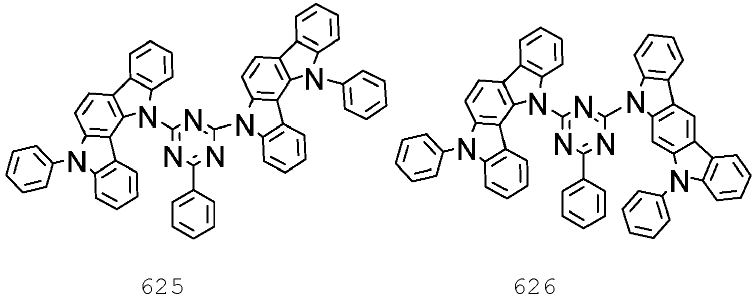

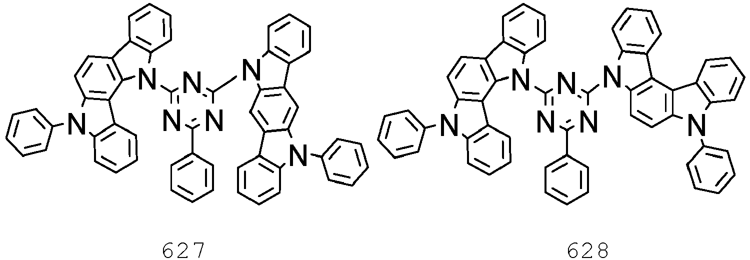

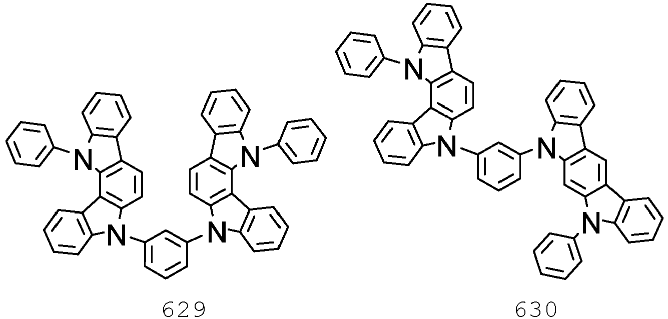

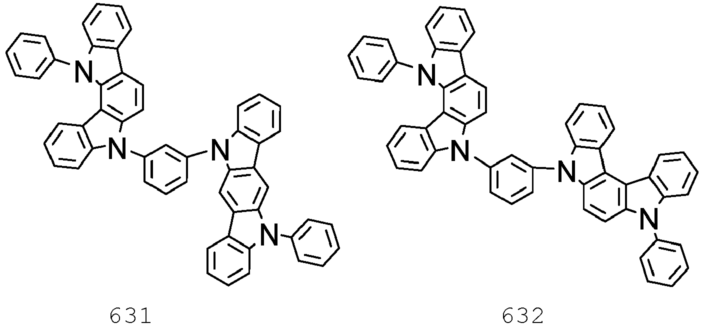

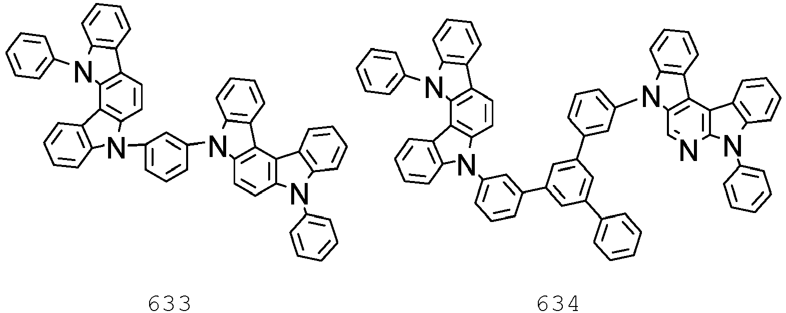

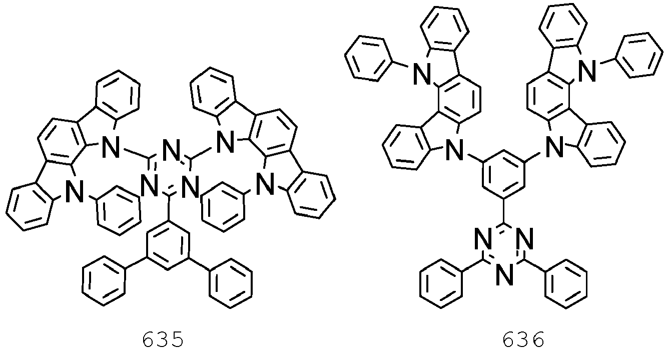

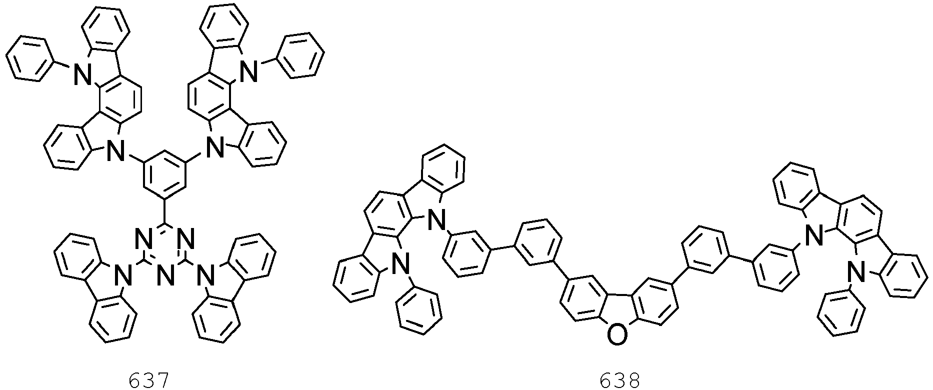

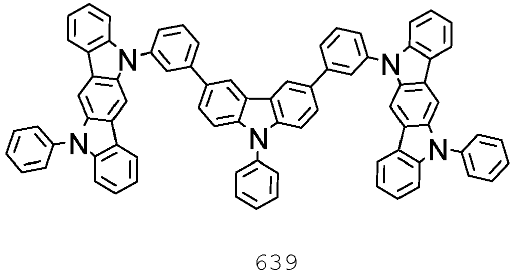

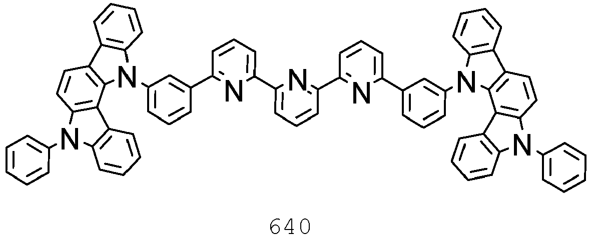

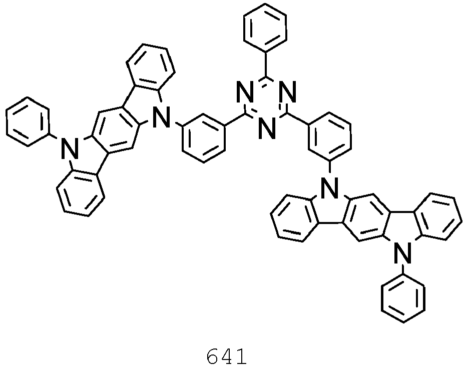

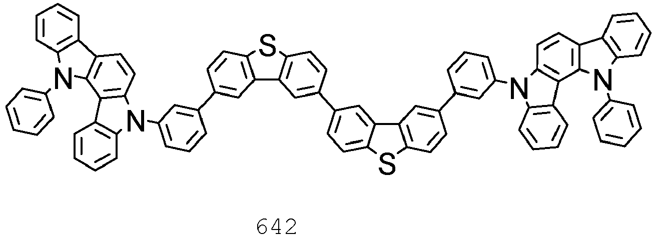

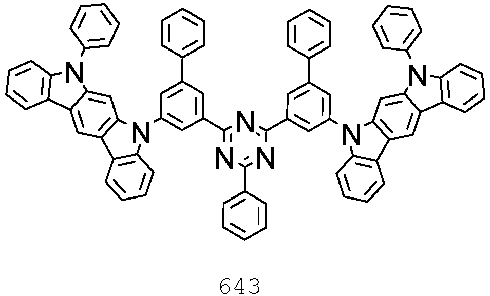

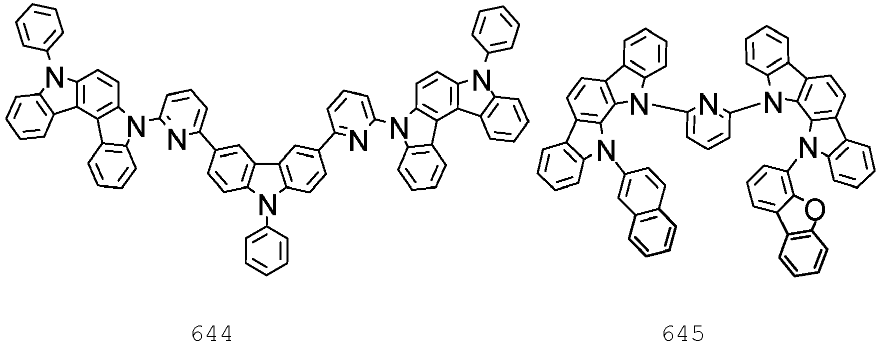

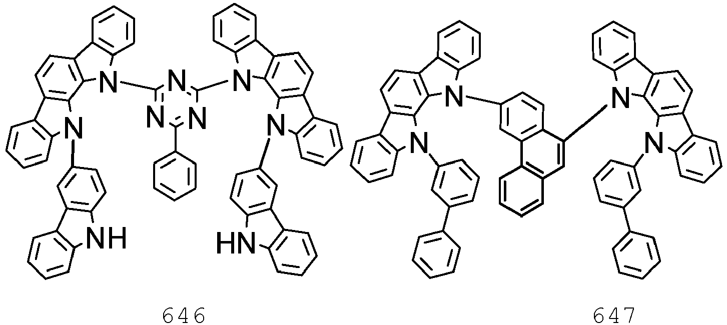

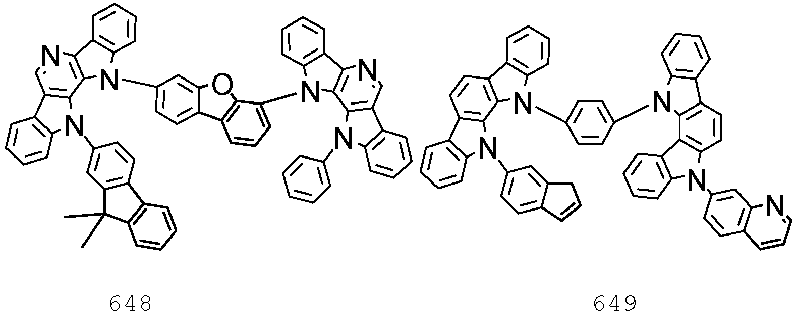

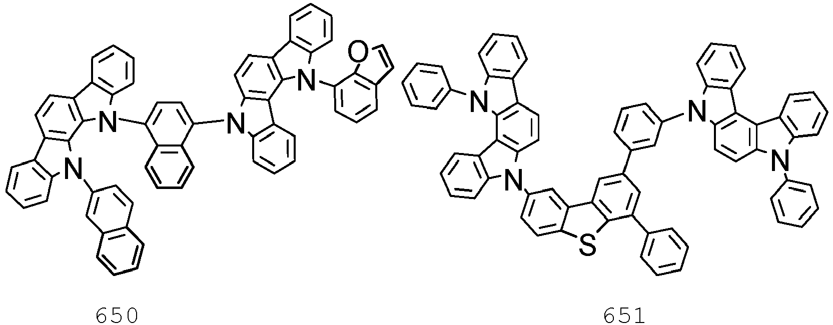

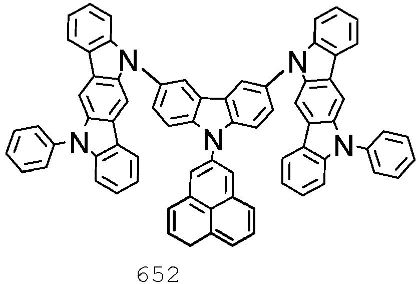

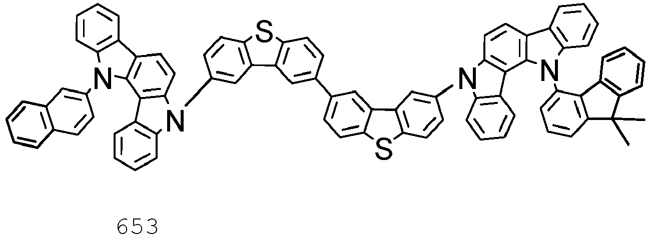

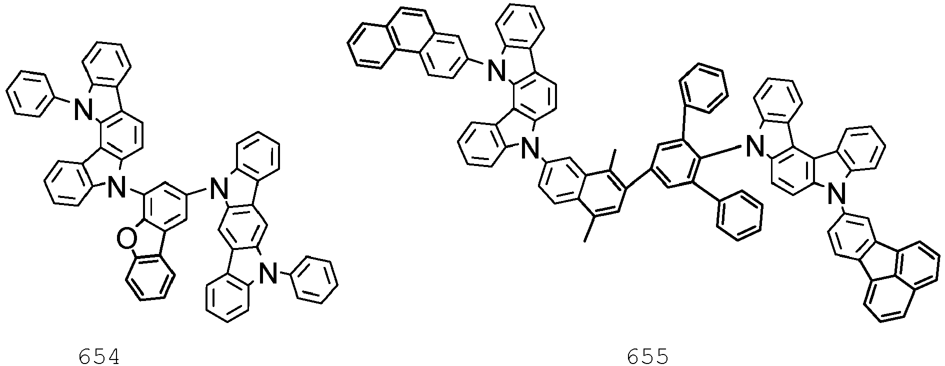

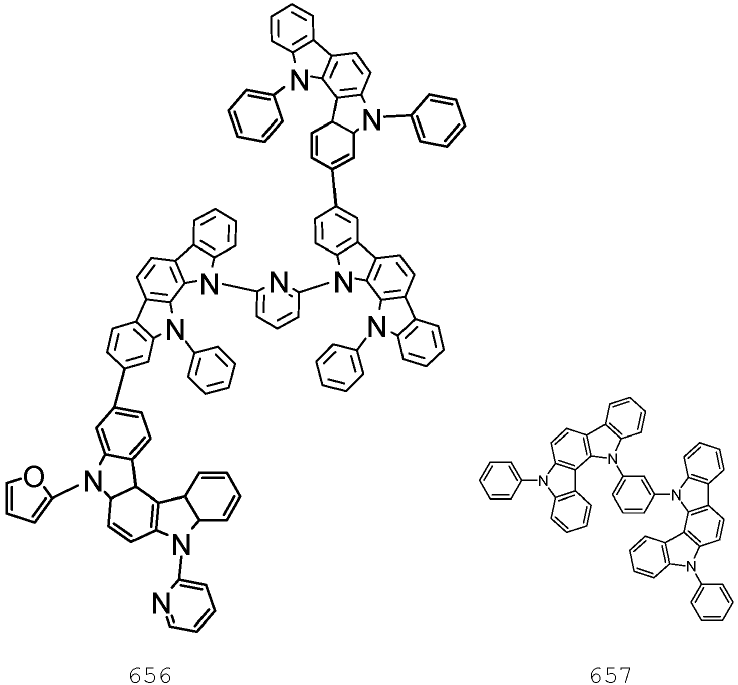

In the organic EL device of the present invention, a mixture containing the first compound represented by the general formula (1) and the second compound represented by the general formula (2) or (3) is incorporated into at least one organic layer of the organic EL device. The mixture may be used in any organic layer because the mixture is excellent in durability against a charge. However, the mixture is preferably incorporated into any one of a light-emitting layer, an electron-blocking layer, and a hole-blocking layer, and is particularly preferably incorporated into the light-emitting layer.

The first compound is selected from one or two or more kinds of compounds each represented by the general formula (1). The second compound is selected from one or two or more kinds of compounds each represented by the general formula (2) or (3). Only the compound represented by the general formula (2) may be used, or only the compound represented by the general formula (3) may be used. With regard to a usage ratio between the first compound and the second compound, the ratio of the first compound is desirably from 10 wt% to 90 wt%, preferably from 30 wt% to 90 wt% with respect to the total of the first compound and the second compound. In addition, the mixture may contain a compound or a material except the first compound and the second compound.

When the mixture is used in the light-emitting layer, the mixture maybe used as a light-emitting dopant material. However, it is preferred that any other phosphorescent light-emitting dopant material, fluorescent light-emitting dopant material, or thermally activated delayed fluorescent light-emitting dopant material be used as the light-emitting dopant material, and the mixture be used as a host material. In particular, a mode in which the phosphorescent light-emitting dopant material is an organometallic complex containing at least one metal selected from ruthenium, rhodium, palladium, silver, rhenium, osmium, iridium, platinum, and gold is preferred.

The at least two compounds for forming the mixture may be mixed and vapor-deposited by using one deposition source before the production of the device, or may be mixed at the time of the production of the device by an operation such as co-deposition involving using a plurality of deposition sources.

In addition, the mixture may be used by being been formed into a film on the substrate or the like through use of a wet process, such as spin coating or an inkjet process, without through use of a dry process involving using a deposition source.

Next, the structure of the organic EL device of the present invention is described with reference to the drawings. However, the structure of the organic EL device of the present invention is by no means limited to one illustrated in the drawings.

### (1) Configuration of Organic EL Device

FIG. 1 is a sectional view for schematically illustrating a structure example of a general organic EL device. Reference numeral 1 represents a substrate, reference numeral 2 represents an anode, reference numeral 3 represents a hole-injecting layer, reference numeral 4 represents a hole-transporting layer, reference numeral 5 represents a light-emitting layer, reference numeral 6 represents an electron-transporting layer, reference numeral 7 represents an electron-injecting layer, and reference numeral 8 represents a cathode. The organic EL device of the present invention includes the anode, the light-emitting layer, the electron-transporting layer, and the cathode as its essential layers, and may include any other layer as required. Examples of the other layer include, but not limited to, a hole-injecting/transporting layer, an electron-blocking layer, and a hole-blocking layer. The hole-injecting/transporting layer means any one or both of the hole-injecting layer and the hole-transporting layer.

### (2) Substrate

The substrate 1 serves as a support for the organic electroluminescent device, and a quartz or glass plate, a metal plate or a metal foil, a plastic film or sheet, or the like is used. A glass plate, or a smooth and transparent plate made of a synthetic resin, such as polyester, polymethacrylate, polycarbonate, or polysulfone, is particularly preferred. When a synthetic resin substrate is used, attention needs to be paid to its gas barrier property. A case in which the gas barrier property of the substrate is excessively small is not preferred because the organic electroluminescent device may deteriorate owing to outside air that has passed the substrate. Accordingly, a method involving providing at least one surface of the synthetic resin substrate with a dense silicon oxide film or the like to secure the gas barrier property is one preferred method.

### (3) Anode

The anode 2 is formed on the substrate 1 and the anode serves to inject a hole into the hole-transporting layer. The anode is typically formed of, for example, a metal, such as aluminum, gold, silver, nickel, palladium, or platinum, a metal oxide, such as an oxide of indium and/or tin, or an oxide of indium and/or zinc, a metal halide, such as copper iodide, carbon black, or a conductive polymer, such as poly(3-methylthiophene), polypyrrole, or polyaniline. The formation of the anode is typically performed by, for example, a sputtering method or a vacuum deposition method in many cases. In addition, in the case of, for example, a metal fine particle made of silver or the like, a fine particle made of copper iodide or the like, carbon black, a conductive metal oxide fine particle, or conductive polymer fine powder, the anode may be formed by dispersing such particle or powder in a proper binder resin solution and applying the dispersion onto the substrate. Further, in the case of a conductive polymer, the anode may be formed by directly forming a thin film of the conductive polymer on the substrate through electrolytic polymerization or by applying the conductive polymer onto the substrate 1. The anode may also be formed by laminating different substances. The thickness of the anode varies depending on transparency to be required. When the transparency is required, the visible light transmittance of the anode is desirably set to 60% or more, preferably 80% or more in ordinary cases . In such cases, the thickness is typically from about 5 nm to about 1,000 nm, preferably from about 10 nm to about 500 nm. When the anode may be opaque, the anode may have the same transmittance as that of the substrate. In addition, another conductive material may be further laminated on the anode.

### (4) Hole-transporting Layer

The hole-transporting layer 4 is formed on the anode 2. The hole-injecting layer 3 may be formed therebetween. A material for the hole-transporting layer is required to satisfy the following conditions: the material needs to have high efficiency with which a hole is injected from the anode and be capable of efficiently transporting the injectedhole. To this end, the material is required to have a small ionization potential, have high transparency for visible light, have a large hole mobility, be excellent in stability, and hardly produce an impurity serving as a trap at the time of the production or use. In addition, the layer is in contact with the light-emitting layer 5, and is hence required neither to quench light emitted from the light-emitting layer nor to form an exciplex between itself and the light-emitting layer to reduce the efficiency. In addition to the above-mentioned general requirements, the device is required to further have heat resistance when its application to an on-vehicle display is considered. Therefore, a material having a Tg of 85°C or more is desired.

The mixture of the compounds represented by the general formula (1) and the general formula (2) or a known compound that has heretofore been used in the layer may be used as a hole-transporting material. Examples of the known compound include: an aromatic diamine which contains two or more tertiary amines and in which a nitrogen atom is substituted with two or more fused aromatic rings; an aromatic amine compound having a starburst structure, such as 4,4',4"-tris(1-naphthylphenylamino)triphenylamine; an aromatic amine compound formed of a tetramer of triphenylamine; and a spiro compound, such as 2,2',7,7'-tetrakis-(diphenylamino)-9,9'-spirobifluorene. Those compounds may be used alone or as a mixture thereof as required.

In addition, examples of the material for the hole-transporting layer other than the above-mentioned compounds include polymer materials, such as polyvinylcarbazole, polyvinyltriphenylamine, and tetraphenylbenzidine-containing polyarylene ether sulfone.

When the hole-transporting layer is formed by an application method, the hole-transporting layer is formed by: adding and dissolving one or two or more kinds of hole-transporting materials, and as required, an additive that does not serve as a trap for a hole, such as a binder resin or an applicability improver, to prepare an application solution; applying the solution onto the anode by a method such as a spin coating method; and drying the applied solution. Examples of the binder resin include polycarbonate, polyarylate, and polyester. When the binder resin is added in a large amount, a hole mobility reduces. Accordingly, the addition amount is desirably as small as possible and is preferably 50 wt% or less in ordinary cases.

When the hole-transporting layer is formed by the vacuum deposition method, the hole-transporting layer is formed by: loading a hole-transporting material into a crucible placed in a vacuum chamber; evacuating the inside of the vacuum chamber to about 10⁻⁴ Pa with a proper vacuum pump; and heating the crucible after the evacuation to evaporate the hole-transporting material. Thus, the hole-transporting layer is formed on the substrate having formed thereon the anode, the substrate being placed to face the crucible. The thickness of the hole-transporting layer is typically from 1 nm to 300 nm, preferably from 5 nm to 100 nm. In general, the vacuum deposition method is frequently employed for uniformly forming such thin film.

### (5) Hole-injecting Layer

The hole-injecting layer 3 has been inserted between the hole-transporting layer 4 and the anode 2 for the purposes of further improving the hole injection efficiency and improving the adhesive force of the entire organic layer to the anode. The insertion of the hole-injecting layer provides the following effects: the initial driving voltage of the device reduces, and at the same time, an increase in voltage when the device is continuously driven at a constant current is suppressed. A material to be used in the hole-injecting layer is required to satisfy the following conditions: the material can be formed into a uniform thin film, which can be satisfactorily brought into contact with the anode, and is thermally stable, i.e., has a high glass transition temperature. The material is required to have a glass transition temperature of 100°C or more. Further, the material is required to satisfy, for example, the following conditions: the material has a low ionization potential and hence facilitates the injection of a hole from the anode; and the material has a large hole mobility.

To this end, the mixture of the compounds represented by the general formula (1) and the general formula (2) may be used, or the following hitherto known materials may be used alone or as a mixture thereof as required: a phthalocyanine compound, such as copper phthalocyanine, an organic compound, such as polyaniline or polythiophene, a sputtered carbon film, a metal oxide, such as a vanadium oxide, a ruthenium oxide, or a molybdenum oxide, and a P-type organic substance, such as 1,4,5,8-naphthalenetetracarboxylic dianhydride (NTCDA) or hexanitrilehexaazatriphenylene (HAT). A thin film serving as the hole-injecting layer can be formed as in the hole-transporting layer . In the case of an inorganic substance, however, the sputtering method, an electron beam deposition method, or a plasma CVD method is further employed. The thickness of the hole-injecting layer to be formed as described above is typically from 1 nm to 300 nm, preferably from 5 nm to 100 nm.

### (6) Light-emitting Layer

The light-emitting layer 5 is formed on the hole-transporting layer 4. The light-emitting layer may be formed of a single light-emitting layer, or may be formed by laminating a plurality of light-emitting layers so that the layers may be in direct contact with each other. The light-emitting layer includes a host material and a light-emitting dopant, and the light-emitting dopant may be any one of a fluorescent light-emitting material, a delayed fluorescent light-emitting material, and a phosphorescent light-emitting material. Although the mixture of the first compound and the second compound may be used as the host material, or may be used as the light-emitting dopant, the mixture is preferably used as the host material.

In the case of a fluorescent light-emitting organic EL device, a fused ring derivative, such as perylene or rubrene, a quinacridonederivative, phenoxazone 660, DCM1, perinone, a coumarin derivative, a pyrromethene (diazaindacene) derivative, a cyanine dye, or the like may be used as the fluorescent light-emit ting material to be added to the host material.

In the case of a delayed fluorescent light-emitting organic EL device, examples of the delayed fluorescent light-emitting material in its light-emitting layer include a carborane derivative, a tin derivative, an indolocarbazole derivative, a copper derivative, and a carbazole derivative. Specific examples thereof include compounds described in the following non patent literatures and patent literature. However, the material is not limited to the compounds.

1) Adv. Mater. 2009, 21, 48064806, 2) Appl. Phys. Lett. 98, 083302 (2011), 3) JP 2011-213643 A, 4) J. Am. Chem. Soc. 2012, 134, 14706-14709.

Specific examples of the delayed fluorescent light-emitting material are shown below. However, the material is not limited to the following compounds.

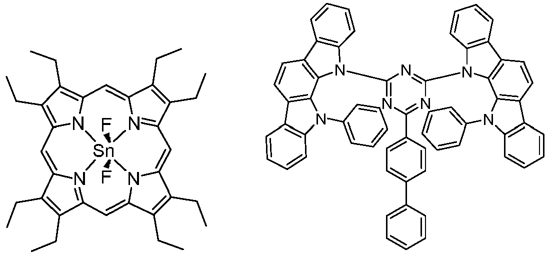

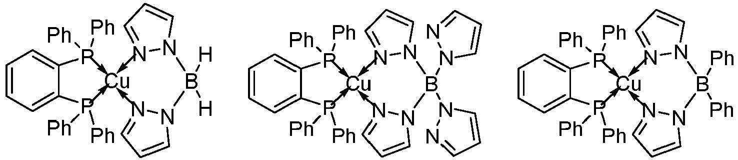

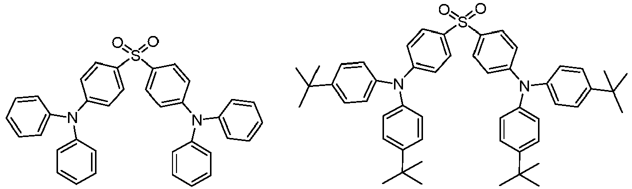

When the delayed fluorescent light-emitting material is used as a delayed fluorescent light-emitting dopant, and the light-emitting layer contains the host material, the amount of the delayed fluorescent light-emitting dopant to be incorporated into the light-emitting layer desirably falls within the range of from 0.01 wt% to 50 wt%, preferably from 0.1 wt% to 20 wt%, more preferably from 0.01 wt% to 10 wt%.

In the case of a phosphorescent light-emitting organic EL device, the phosphorescent light-emitting dopant desirably contains an organometallic complex containing at least one metal selected from, for example, ruthenium, rhodium, palladium, silver, rhenium, osmium, iridium, platinum, and gold. Specific examples thereof include, but not limited to, compounds described in the following patent literatures.

WO 2009/073245 A1, WO 2009/046266 A1, WO 2007/095118 A2, WO 2008/156879 A1, WO 2008/140657 A1, US 2008/261076 A, JP 2008-542203 A, WO 2008/054584 A1, JP 2008-505925 A, JP 2007-522126 A, JP 2004-506305A, JP 2006-513278 A, JP 2006-50596A, WO 2006/046980 A1, WO 2005/53704 A1, US 2005/260449 A, US 2005/2260448 A, US 2005/214576 A, WO 2005/076380 A1, and the like.

Preferred examples of the phosphorescent light-emitting dopant include complexes such as Ir (ppy) 3, complexes such as Ir (bt) 2 · acac3, and complexes such as PtOEt3, the complexes each having a noble metal element, such as Ir, as a central metal. Specific examples of those complexes are shown below, but the complexes are not limited to the following compounds.

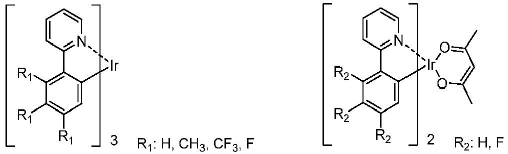

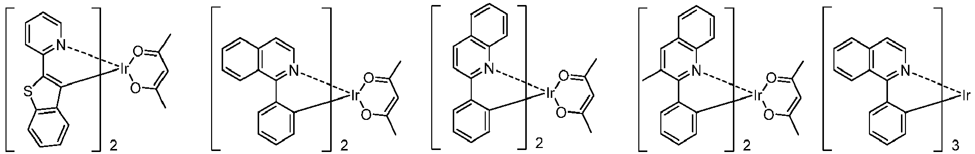

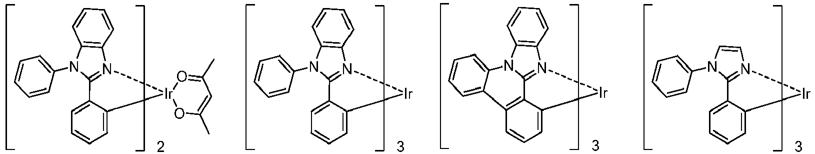

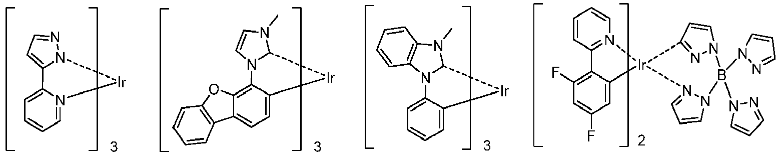

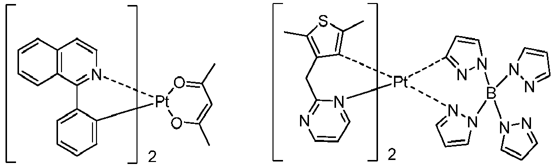

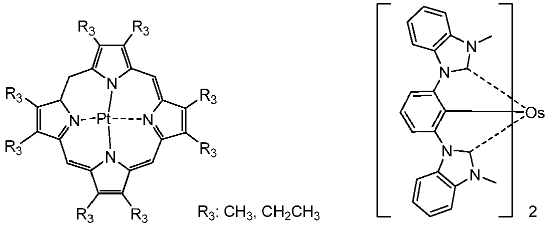

The content of the phosphorescent light-emitting dopant in the light-emitting layer desirably falls within the range of from 2 wt% to 40 wt%, preferably from 5 wt% to 30 wt%.

The thickness of the light-emitting layer, which is not particularly limited, is typically from 1 nm to 300 nm, preferably from 5 nm to 100 nm, and a thin film serving as the layer is formed by the same method as that for the hole-transporting layer.

### -Blocking Layer-

Ablocking layer can block the diffusion of a charge (an electron or a hole) and/or an exciton present in the light-emitting layer to the outside of the light-emitting layer. An electron-blocking layer may be arranged between the light-emitting layer and the hole-transporting layer, and blocks the passage of an electron through the light-emitting layer toward the hole-transporting layer . Similarly, a hole-blocking layer may be arranged between the light-emitting layer and the electron-transporting layer, and blocks the passage of a hole through the light-emitting layer toward the electron-transporting layer. Each of the blocking layers may also be used for blocking the diffusion of an exciton to the outside of the light-emitting layer. That is, each of the electron-blocking layer and the hole-blocking layer can also function as an exciton-blocking layer. The term electron-blocking layer or hole-blocking layer as used herein is used in a meaning including a layer having functions of a charge (electron or hole)-blocking layer and the exciton-blocking layer alone.

### -Hole-blocking Layer-

The hole-blocking layer has a function of an electron-transporting layer in a broad sense. The hole-blocking layer serves to block the arrival of a hole at the electron-transporting layer while transporting an electron. Thus, the probability of recombining an electron and a hole in the light-emitting layer can be improved.

The mixture of the compounds represented by the general formula (1) and the general formula (2) is preferably used as a material for the hole-blocking layer, and a material for the electron-transporting layer to be described later may also be used. The thickness of the hole-blocking layer according to the present invention is preferably from 3 nm to 100 nm, more preferably from 5 nm to 30 nm.

### -Electron-blocking Layer-

The electron-blocking layer has a hole-transporting function in a broad sense. The electron-blocking layer serves to block the arrival of an electron at the hole-transporting layer while transporting a hole. Thus, the probability of recombining an electron and a hole in the light-emitting layer can be improved.

The mixture of the compounds represented by the general formula (1) and the general formula (2) is preferably used as a material for the electron-blocking layer, and a material for the hole-transporting layer to be described later may also be used. The thickness of the electron-blocking layer according to the present invention is preferably from 3 nm to 100 nm, more preferably from 5 nm to 30 nm.

### -Exciton-blocking Layer-

The exciton-blocking layer is a layer for blocking the diffusion of an exciton, which is produced by the recombination of a hole and an electron in the light-emitting layer, to a charge-transporting layer. The insertion of the layer enables efficient confinement of the exciton in the light-emitting layer, and hence can improve the luminous efficiency of the device. The exciton-blocking layer may be inserted into any one of an anode side and a cathode side so as to be adjacent to the light-emitting layer, and such layers may be simultaneously inserted into both the sides. That is, when the device includes the exciton-blocking layer on the anode side, the layer may be inserted into a space between the hole-transporting layer and the light-emitting layer so as to be adjacent to the light-emitting layer, and when the layer is inserted into the cathode side, the layer may be inserted into a space between the light-emitting layer and the cathode so as to be adjacent to the light-emitting layer. In addition, the device may include the hole-injecting layer, the electron-blocking layer, or the like between the anode and the exciton-blocking layer adjacent to the anode side of the light-emitting layer, and may include the electron-injecting layer, the electron-transporting layer, the hole-blocking layer, or the like between the cathode and the exciton-blocking layer adjacent to the cathode side of the light-emitting layer.

The mixture of the compounds represented by the general formula (1) and the general formula (2) or (3) is preferably used as a material for the exciton-blocking layer, and an arbitrary material to be generally used may also be used.

A known material for the exciton-blocking layer that may be used is, for example, 1,3-dicarbazolylbenzene (mCP) or bis(6-methyl-8-quinolinolato)-4-phenylphenolatoaluminum(III) (BAlq) .

### (7) Electron-transporting Layer

The electron-transporting layer 6 is arranged between the light-emitting layer 5 and the cathode 8 for the purpose of further improving the luminous efficiency of the device. A material for the electron-transporting layer is preferably an electron-transportable material that enables smooth injection of an electron from the cathode, the mixture of the compounds represented by the general formula (1) and the general formula (2) may be used, and an arbitrary material to be generally used may be used. Examples of the electron-transporting material that satisfies such condition include a metal complex such as Alq3, a metal complex of 10-hydroxybenzo[h]quinoline, an oxadiazole derivative, a distyrylbiphenyl derivative, a silole derivative, a 3- or 5-hydroxyflavone metal complex, a benzoxazole metal complex, a benzothiazole metal complex, trisbenzimidazolylbenzene, a quinoxaline compound, a phenanthroline derivative, 6-t-butyl-9,10-N,N'-dicyanoanthraquinonediimine, n-type hydrogenated amorphous silicon carbide, n-type zinc sulfide, and n-type zinc selenide.

The thickness of the electron-transporting layer is typically from 1 nm to 300 nm, preferably from 5 nm to 100 nm. The electron-transporting layer is formed through lamination on the light-emitting layer by the application method or the vacuum deposition method as in the hole-transporting layer. The vacuum deposition method is typically employed.

### (8) Cathode

The cathode 8 serves to inject an electron into the electron-transporting layer 6. Although the material to be used in the anode 2 may be used as a material to be used as the cathode, a metal having a lowwork function is preferred for efficient electron injection, and a proper metal, such as tin, magnesium, indium, calcium, aluminum, or silver, or an alloy thereof is used. Specific examples of the cathode include low-work function alloy electrodes made of a magnesium-silver alloy, a magnesium-indium alloy, and an aluminum-lithium alloy.

The thickness of the cathode is typically the same as that of the anode. When a metal layer that has a high work function and is stable against the air is further laminated on the cathode formed of a low-work function metal for the purpose of protecting the cathode, the stability of the device is improved. To this end, a metal such as aluminum, silver, copper, nickel, chromium, gold, or platinum is used.

Further insertion of an extremely thin insulating film (having a thickness of from 0.1 nm to 5 nm) made of LiF, MgF₂, Li₂O, or the like as the electron-injecting layer 7 into a space between the cathode 8 and the electron-transporting layer 6 is also an effective method of improving the efficiency of the device.

A structure in inverse relation to that illustrated in FIG. 1 is permitted, i.e., the cathode 8, the electron-injecting layer 7, the electron-transporting layer 6, the light-emitting layer 5, the hole-transporting layer 4, the hole-injecting layer 3, and the anode 2 may be laminated in the stated order on the substrate 1, and as described above, the organic EL device of the present invention may be arranged between two substrates, at least one of which has high transparency. In this case as well, a layer may be added or omitted as required.

The organic EL device of the present invention may be any one of a single device, a device formed of structures arranged in an array manner, and a structure in which the anode and the cathode are arranged in an X-Y matrix manner. According to the organic EL device of the present invention, the two compounds of the present invention are used in at least one organic layer; in particular, the compounds are used as a mixed host material for the light-emitting layer. Accordingly, a device, which has high luminous efficiency and is largely improved in driving stability even at a low voltage, is obtained, and can exhibit excellent performance in its application to a full-color or multi-color panel.

The present invention is described in more detail below by way of Examples. However, the present invention is not limited to Examples below, and may be carried out in various modes as long as the modes do not deviate from the gist thereof. The terms first host and first component each mean a host compound represented by the general formula (1), and the terms secondhost and second component each mean a host compound represented by the general formula (2) or (3).

### Examples

### Synthesis Example 1

Compound 101 is synthesized in accordance with the following reaction formulae.

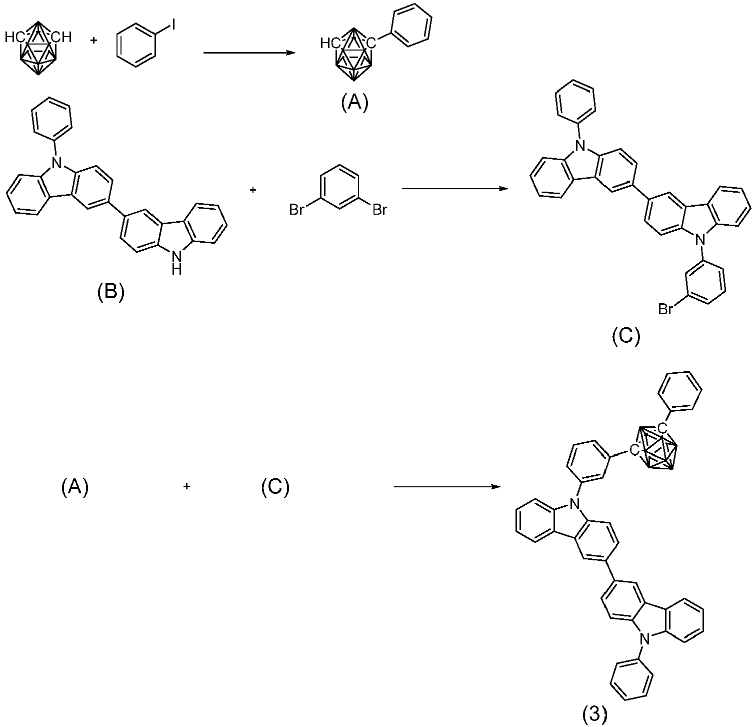

Under a nitrogen atmosphere, 35.0 g (0.243 mol) of m-carborane and 340 mL of 1,2-dimethoxyethane (DME) were added, and the resultant DME solution was cooled to 0°C. 96.6 mL of a 2.69 M solution of n-butyllithium in hexane was dropped to the solution, and the mixture was stirred for 30 min under ice cooling. 70 mL of pyridine was added to the mixture, and the whole was stirred at room temperature for 10 min. After that, 74.6 g (0.753 mol) of copper (I) chloride was added to the resultant, and the mixture was stirred at 65°C for 30 min. After that, 53.0 g (0.260 mol) of iodobenzene was added to the mixture, and the whole was stirred at 95°C overnight. After the reaction solution had been cooled to room temperature, the precipitated crystal was filtered out, and the solvent was evaporated under reduced pressure. The resultant residue was purified by silica gel column chromatography to provide 38.7 g (0.191 mol, yield: 78.8%) of an intermediate A.

Under a nitrogen atmosphere, 61.2 g (0.15 mol) of a compound B, 53.1 g (0.23 mol) of 2, 6-dibromobenzene, 5.60 g (0.028 mol) of copper iodide, 160 g (0.760 mol) of tripotassium phosphate, 34.0 g (0.30 mol) of trans-1,2-cyclohexanediamine, and 1.5 L of 1, 4-dioxane were added, and the mixture was stirred at 120 °C overnight. After the reaction solution had been cooled to room temperature, the precipitated crystal was filtered out, and the solvent was evaporated under reduced pressure. The resultant residue was purified by silica gel column chromatography to provide 51.0 g (90.5 mmol, yield: 60.3%) of an intermediate C as a white solid.

Under a nitrogen atmosphere, 7.7 g (0.0383 mol) of the intermediate A and 85 mL of DME were added, and the resultant DME solution was cooled to 0°C. 15.0 mL of a 2.65 M solution of n-butyllithium in hexane was dropped to the solution, and the mixture was stirred for 30 min under ice cooling. 10.5 mL of pyridine was added to the mixture, and the whole was stirred at room temperature for 10 min. After that, 11.8 g (0.118 mol) of copper(I) chloride was added to the resultant, and the mixture was stirred at 65°C for 30 min. After that, 23 g (0.041 mol) of the intermediate C was added to the mixture, and the whole was stirred at 95°C for 2.5 d. After the reaction solution had been cooled to room temperature, the precipitated crystal was filtered out, and the solvent was evaporated under reduced pressure. The resultant residue was purified by silica gel column chromatography to provide 4.2 g (5.90 mmol, yield: 15.4%) of a compound 3. The compound 3 corresponds to Compound 101.

### Example 1

Each thin film was laminated on a glass substrate having formed thereon an anode formed of indium tin oxide (ITO) having a thickness of 70 nm by a vacuum deposition method at a degree of vacuum of 2.0×10⁻⁵ Pa. First, copper phthalocyanine (CuPC) was formed into a hole-injecting layer having a thickness of 30 nm on ITO. Next, 4,4-bis [N-(1-naphthyl) -N-phenylamino]biphenyl (NPB) was formed into a hole-transporting layer having a thickness of 15 nm. Next, Compound 101 serving as a first host for a light-emitting layer, Compound 490 serving as a second host therefor, and an iridium complex [iridium(III)
bis(4,6-di-fluorophenyl)-pyridinato-N,C2']picolinate] (FIrpic), which was a blue phosphorescent material, serving as a light-emitting layer guest were co-deposited from different deposition sources to form a light-emitting layer having a thickness of 30 nm. At this time, a deposition rate ratio (weight ratio) among the first host, the second host, and FIrpic was 47: 47: 6. Next, Alq₃ was formed into an electron-transporting layer having a thickness of 25 nm. Further, lithium fluoride (LiF) was formed into an electron-injecting layer having a thickness of 1.0 nm on the electron-transporting layer. Finally, aluminum (Al) was formed into an electrode having a thickness of 70 nm on the electron-injecting layer. The resultant organic EL device has such a layer configuration that in the organic EL device illustrated in FIG. 1, the electron-injecting layer is added between the cathode and the electron-transporting layer.

### Examples 2 to 8

Organic EL devices were each produced in the same manner as in Example 1 except that in Example 1, a compound shown in Table 1 was used as the first host for the light-emitting layer.

### Examples 9 to 24

Organic EL devices were each produced in the same manner as in Example 1 except that: one of Compounds 506 and 657 was used as the second host for the light-emitting layer; and a compound shown in Table 1 was used as the second host.

### Comparative Examples 1 to 5

Organic EL devices were each produced in the same manner as in Example 1 except that in Example 1, a compound shown in Table 1 was used alone as the light-emitting layer host. The amount of the host was the same as the total amount of the first host and the second host in Example 1, and the amount of the guest was the same as that in Example 1.

A power source was connected to each of the organic EL devices obtained in Examples and Comparative Examples to apply a DC voltage to the device. As a result, an emission spectrum having a local maximum wavelength of 475 nm from each of the organic EL devices was observed, and hence it was found that light emission from FIrpic was obtained. The characteristics of the produced organic EL devices are shown in Table 1.

In Table 1, luminances, voltages, and luminous efficiencies are values at a driving current of 2.5 mA/cm², and luminance half-times are values at an initial luminance of 1,000 cd/m². Compound Nos. are numbers given to the above-mentioned chemical formulae.

**Table 1**

| | First host compound No. | Second host compound No. | Luminance (cd/m²) | Voltage (V) | Visual luminous efficiency (lm/W) | Luminance half-time (h) |
|---|---|---|---|---|---|---|
| Ex. 1 | 101 | 490 | 464 | 9.5 | 6.2 | 1,900 |
| Ex. 2 | 106 | | 441 | 7.6 | 7.3 | 1, 600 |
| Ex. 3 | 110 | | 464 | 9.1 | 6.4 | 1, 900 |
| Ex. 4 | 119 | | 463 | 9.1 | 6.4 | 1, 800 |
| Ex. 5 | 122 | | 463 | 9.9 | 5.9 | 1,800 |
| Ex. 6 | 123 | | 463 | 8.3 | 7.0 | 1,800 |
| Ex. 7 | 117 | | 423 | 7.3 | 7.3 | 1,500 |
| Ex. 8 | 176 | | 464 | 9.6 | 6.1 | 1,700 |
| Ex. 9 | 101 | 506 | 465 | 8.1 | 7.3 | 2,000 |
| Ex. 10 | 106 | | 442 | 6.3 | 8.6 | 1, 900 |
| Ex. 11 | 110 | | 465 | 7.7 | 7.5 | 2, 000 |
| Ex. 12 | 119 | | 463 | 7.7 | 7.5 | 2,000 |
| Ex. 13 | 122 | | 463 | 8.4 | 6.9 | 2,000 |
| Ex. 14 | 123 | | 463 | 7.1 | 8.2 | 1,900 |
| Ex. 15 | 117 | | 424 | 6.2 | 8.6 | 1,700 |
| Ex. 16 | 176 | | 465 | 8.2 | 7.2 | 1,800 |
| Ex. 17 | 101 | 657 | 465 | 10.2 | 5.7 | 1,900 |
| Ex. 18 | 106 | | 442 | 8.1 | 6.8 | 1,600 |
| Ex. 19 | 110 | | 465 | 9.8 | 6.0 | 1,900 |
| Ex. 20 | 119 | | 464 | 9.8 | 5.9 | 1,800 |
| Ex. 21 | 122 | | 464 | 10.6 | 5.5 | 1,800 |
| Ex. 22 | 123 | | 464 | 9.0 | 6.5 | 1,800 |
| Ex. 23 | 117 | | 424 | 7.8 | 6.8 | 1,500 |
| Ex. 24 | 176 | | 465 | 10.3 | 5.7 | 1,700 |
| Comp. Ex. 1 | - | 490 | 378 | 10.0 | 4.8 | 480 |
| Comp. Ex. 2 | - | 506 | 376 | 9.0 | 5.2 | 600 |
| Comp. Ex. 3 | 101 | - | 387 | 9.5 | 5.1 | 370 |
| Comp. Ex. 4 | 122 | - | 386 | 10.0 | 4.8 | 357 |
| Comp. Ex. 5 | - | 657 | 380 | 11.8 | 4.0 | 500 |

### Example 25

Each thin film was laminated by a vacuum deposition method at a degree of vacuum of 4.0×10⁻⁴ Pa on a glass substrate on which an anode formed of ITO having a thickness of 150 nm had been formed. First, CuPc was formed into a hole-inj ecting layer having a thickness of 20 nm on ITO. Next, NPB was formed into a hole-transporting layer having a thickness of 20 nm. Next, Compound 101 serving as a first host, Compound 657 serving as a second host, and tris(6-phenylpyridine)iridium(III) (Ir(PPy)₃) serving as a light-emitting layer guest were co-deposited from deposition sources different from each other to form a light-emitting layer having a thickness of 30 nm. At this time, a deposition rate ratio among the first host, the second host, and Ir(PPy)₃ was 47 : 47 : 6. Next, aluminum(III) bis(6-methyl-8-quinolinolato)-4-phenylphenolate (BAlq) was formed into a hole-blocking layer having a thickness of 10 nm. Next, Alq₃ was formed into an electron-transporting layer having a thickness of 40 nm. Further, LiF was formed into an electron-injecting layer having a thickness of 0.5 nm on the electron-transporting layer. Finally, A1 was formed into a cathode having a thickness of 100 nm on the electron-injecting layer. Thus, an organic EL device was produced.

### Examples 26 to 48

Organic EL devices were each produced in the same manner as in Example 25 except that in Example 25, a compound shown in Table 2 was used as the first host for the light-emitting layer (Examples 26 to 32).

In addition, organic EL devices were each produced in the same manner as in Example 25 except that one of Compounds 403 and 657 was used as the second host for the light-emitting layer (Examples 33 to 48).

### Comparative Examples 6 to 10

Organic EL devices were each produced in the same manner as in Example 19 except that in Example 19, a compound shown in Table 2 was used alone as a light-emitting layer host. The amount of the host was the same as the total amount of the first host and the second host in Example 19, and the amount of the guest was the same as that in Example 19.

A power source was connected to each of the organic EL devices obtained in Examples and Comparative Examples to apply a DC voltage to the device. As a result, an emission spectrum having a local maximum wavelength of 517 nm from each of the organic EL devices was observed, and hence it was found that light emission from Ir(PPy)₃ was obtained. The characteristics of the produced organic EL devices are shown in Table 2.

In Table 2, luminances, voltages, and luminous efficiencies are values at a driving current of 20 mA/cm², and luminance half-times are values at an initial luminance of 1,000 cd/m².

**Table 2**

| | First host compound No. | Second host compound No. | Luminance (cd/m²) | Voltage (V) | Visual luminous efficiency (lm/W) | Luminance half-time (h) |
|---|---|---|---|---|---|---|
| Ex. 25 | 101 | 402 | 11,800 | 6.8 | 27.1 | 15,900 |
| Ex. 26 | 106 | | 11,200 | 5.4 | 32.3 | 14,000 |
| Ex. 27 | 110 | | 11,800 | 6.6 | 28.2 | 16,100 |
| Ex. 28 | 119 | | 11,700 | 6.6 | 28.1 | 15,700 |
| Ex. 29 | 122 | | 11,700 | 7.1 | 25.9 | 15,500 |
| Ex. 30 | 123 | | 11,700 | 6.0 | 30.7 | 15,200 |
| Ex. 31 | 117 | | 10,700 | 5.2 | 32.1 | 12,400 |
| Ex. 32 | 176 | | 11,800 | 6.9 | 26.8 | 14,500 |
| Ex. 33 | 101 | 403 | 10,800 | 6.6 | 25.5 | 16,100 |
| Ex. 34 | 106 | | 10,200 | 5.3 | 30.4 | 14,800 |
| Ex. 35 | 110 | | 10,800 | 6.4 | 26.6 | 16,200 |
| Ex. 36 | 119 | | 10,700 | 6.4 | 26.5 | 15,900 |
| Ex. 37 | 122 | | 10,700 | 6.9 | 24.4 | 15,700 |
| Ex. 38 | 123 | | 10,700 | 5.8 | 28.9 | 15,400 |
| Ex. 39 | 117 | | 9,800 | 5.1 | 30.2 | 13,800 |
| Ex. 40 | 176 | | 10,800 | 6.7 | 25.2 | 14,700 |
| Ex. 41 | 101 | 657 | 11,800 | 7.1 | 26.1 | 14,900 |
| Ex. 42 | 106 | | 11,200 | 5.7 | 31.0 | 13,100 |
| Ex. 43 | 110 | | 11,800 | 6.8 | 27.1 | 15,000 |
| Ex. 44 | 119 | | 11,700 | 6.8 | 27.0 | 14,700 |
| Ex. 45 | 122 | | 11,700 | 7.4 | 24.9 | 14,500 |
| Ex. 46 | 123 | | 11,700 | 6.2 | 29.5 | 14,200 |
| Ex. 47 | 117 | | 10,700 | 5.5 | 30.9 | 11,700 |
| Ex. 48 | 176 | | 11,800 | 7.2 | 25.7 | 13,600 |
| Comp. Ex. 6 | - | 402 | 9,000 | 5.5 | 25.7 | 5,000 |
| Comp. Ex. 7 | - | 403 | 8,000 | 5.0 | 25.1 | 4,000 |
| Comp. Ex. 8 | 101 | - | 9,800 | 7.0 | 22.0 | 2,900 |
| Comp. Ex. 9 | 122 | - | 9,800 | 7.4 | 20.8 | 2,900 |
| Comp. Ex. 10 | - | 657 | 9,600 | 8.2 | 18.5 | 4,000 |

### Ex. 49

Each thin film was laminated on a glass substrate having formed thereon an anode formed of indium tin oxide (ITO) having a thickness of 70 nm by a vacuum deposition method at a degree of vacuum of 2.0×10⁻⁵ Pa. First, copper phthalocyanine (CuPC) was formed into a hole-injecting layer having a thickness of 30 nm on ITO. Next, diphenylnaphthyldiamine (NPD) was formed into a hole-transporting layer having a thickness of 15 nm. Next, mCBP serving as a host material for a light-emitting layer and FIrpic serving as a dopant were co-deposited from different deposition sources onto the hole-transporting layer to form a light-emitting layer having a thickness of 30 nm. At this time, a deposition rate ratio between mCBP and FIrpic was 94:6. Next, a hole-blocking layer having a thickness of 5 nm was formed on the light-emitting layer by using Compound 106 as a first component and Compound 402 as a second component. At this time, a deposition rate ratio between Compound 106 and Compound 402 was 50:50. Next, Alq₃ was formed into an electron-transporting layer having a thickness of 20 nm. Further, lithium fluoride (LiF) was formed into an electron-injecting layer having a thickness of 1.0 nm on the electron-transporting layer. Finally, aluminum (Al) was formed into an electrode having a thickness of 70 nm on the electron-injecting layer. The resultant organic EL device has such a layer configuration that in the organic EL device illustrated in FIG. 1, the electron-injecting layer is added between the cathode and the electron-transporting layer, and the hole-blocking layer is added between the light-emitting layer and the electron-transporting layer.

### Examples 50 and 51

Organic EL devices were each produced in the same manner as in Example 49 except that in Example 49, a compound shown in Table 3 was used as the first component for the hole-blocking layer.

### Examples 52 to 54

Organic EL devices were each produced in the same manner as in Example 49 except that: Compound 403 was used as the second component for the hole-blocking layer; and a compound shown in Table 3 was used as the first component therefor.

### Comparative Example 11

An organic EL device was produced in the same manner as in Example 49 except that: the thickness of Alq₃ serving as the electron-transporting layer in Example 49 was set to 25 nm; and the hole-blocking layer was not arranged.

When an external power source was connected to each of the organic EL devices obtained in Examples and Comparative Examples to apply a DC voltage to the device, it was confirmed that the device had such light emission characteristics as shown in Table 3. Luminances, voltages, and luminous efficiencies show values (initial characteristics) when the devices are driven at 2.5 mA/cm². The emission spectrum of each of those organic EL devices had a local maximum wavelength of 475 nm, and hence it was identified that light emission from FIrpic was obtained.

**Table 3**

| | First component compound No. | Second component compound No. | Luminance (cd/m²) | Voltage (V) | Visual luminous efficiency (lm/W) | Luminance half-time (h) |
|---|---|---|---|---|---|---|
| Ex. 49 | 106 | 402 | 689 | 9.5 | 9.1 | 1,700 |
| Ex. 50 | 117 | | 719 | 9.3 | 9.8 | 1, 800 |
| Ex. 51 | 176 | | 655 | 11.1 | 7.4 | 1, 600 |
| Ex. 52 | 101 | 403 | 668 | 9.3 | 9.0 | 1,700 |
| Ex. 53 | 106 | | 697 | 9.1 | 9.7 | 1, 800 |
| Ex. 54 | 110 | | 635 | 10.8 | 7.4 | 1, 600 |
| Comp. Ex. 11 | - | - | 520 | 9.4 | 7.0 | 300 |

### Reference Signs List

- 1: substrate
- 2: anode
- 3: hole-injecting layer
- 4: hole-transporting layer
- 5: light-emitting layer
- 6: electron-transporting layer
- 7: electron-injecting layer
- 8: cathode

## Claims

1. An organic electroluminescent device having laminated, on a substrate, an anode, organic layers, and a cathode, wherein at least one layer of the organic layers contains (i) a first compound represented by the following general formula (1) and (ii) a second compound represented by the following general formula (2) or general formula (3): 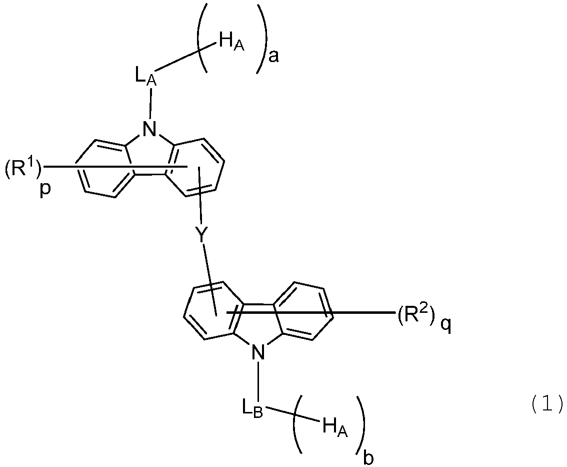 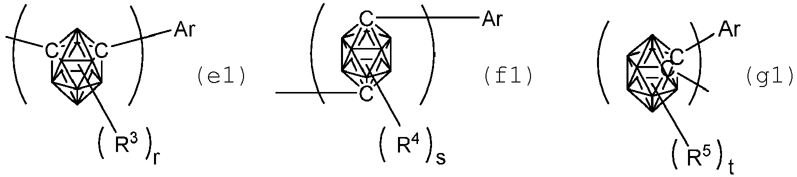 wherein:
H_{A} represents a carborane ring-containing group represented by the formula (e1), the formula (f1), or the formula (g1), and when the plurality of groups are present in a molecule of the compound, the groups may be identical to or different from each other;
Ars each independently represent hydrogen, a substituted or unsubstituted aromatic hydrocarbon group having 6 to 30 carbon atoms, a substituted or unsubstituted aromatic heterocyclic group having 3 to 16 carbon atoms, a substituted or unsubstituted linked aromatic group obtained by linking 2 to 6 aromatic rings of the aromatic hydrocarbon group or the aromatic heterocyclic group, an alkyl group having 1 to 20 carbon atoms, or an aralkyl group having 7 to 38 carbon atoms;
R¹ to R⁵ each independently represent a substituted or unsubstituted aromatic hydrocarbon group having 6 to 30 carbon atoms, a substituted or unsubstituted aromatic heterocyclic group having 3 to 16 carbon atoms, a substituted or unsubstituted linked aromatic group obtained by linking 2 to 6 aromatic rings of the aromatic hydrocarbon group or the aromatic heterocyclic group, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, a cyano group, a nitro group, a fluoro group, or a tosyl group, and in a case of a group except the cyano group, the nitro group, the fluoro group, and the tosyl group, the group may further have a substituent;
Y represents a single bond, a divalent substituted or unsubstituted aromatic hydrocarbon group having 6 to 30 carbon atoms, a divalent substituted or unsubstituted aromatic heterocyclic group having 3 to 16 carbon atoms, or a divalent substituted or unsubstituted linked aromatic group obtained by linking 2 to 6 aromatic rings of the aromatic hydrocarbon group or the aromatic heterocyclic group;
L_{A} and L_{B} each represent a single bond, a substituted or unsubstituted aromatic hydrocarbon group having 6 to 30 carbon atoms, a substituted or unsubstituted aromatic heterocyclic group having 3 to 30 carbon atoms, or a substituted or unsubstituted linked aromatic group obtained by linking 2 to 6 aromatic rings of the aromatic hydrocarbon group or the aromatic heterocyclic group, provided that L_{A} represents an a+1-valent group and L_{B} represents a b+1-valent group, and when a or b represents 0, L_{A} or L_{B} may represent hydrogen, and when a or b represents 1, L_{A} or L_{B} may represent a single bond; and
p, q, r, s, t, a, and b each represent a substitution number, p and q each independently represent an integer of from 0 to 7, r, s, and t each independently represent an integer of from 0 to 10, a and b each independently represent an integer of from 0 to 5, and a+b represents an integer of from 1 to 5; 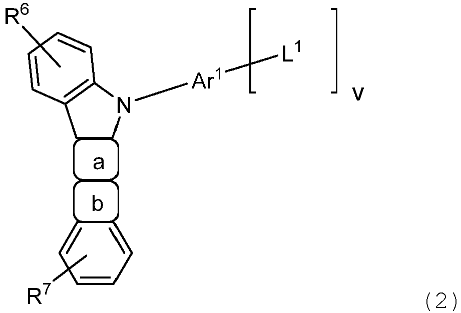 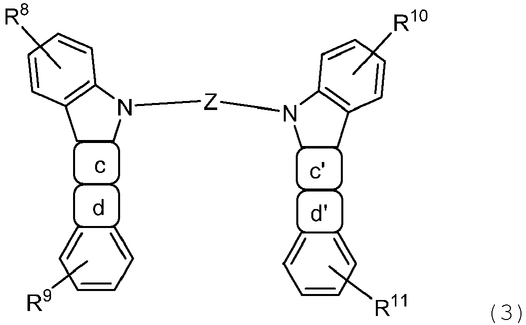 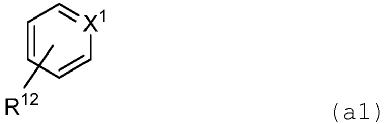 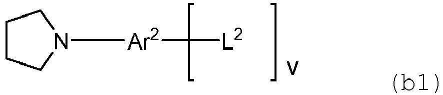 wherein:
a ring a, a ring c, and a ring c' each independently represent an aromatic ring represented by the formula (a1), which is fused with two adjacent rings at arbitrary positions, and X¹ represents C-R or N;
a ring b, a ring d, and a ring d' each independently represent a heterocycle represented by the formula (b1), which is fused with two adjacent rings at arbitrary positions;
Ar¹ and Ar² each independently represent a v+1-valent aromatic hydrocarbon group having 6 to 30 carbon atoms, or a v+1-valent aromatic heterocyclic group having 3 to 16 carbon atoms, and Z represents a divalent aromatic hydrocarbon group having 6 to 30 carbon atoms, a divalent aromatic heterocyclic group having 3 to 16 carbon atoms, or a divalent linked aromatic group obtained by linking 2 to 10 aromatic rings of the aromatic hydrocarbon group or the aromatic heterocyclic group;
L¹ and L² each independently represent an aromatic hydrocarbon group having 6 to 30 carbon atoms, an aromatic heterocyclic group having 3 to 16 carbon atoms, or a linked aromatic group obtained by linking 2 to 10 aromatic rings of the aromatic hydrocarbon group or the aromatic heterocyclic group, and vs each independently represent a substitution number, and each independently represent an integer of from 0 to 7;
R⁶ to R¹² each independently represent hydrogen, an alkyl group having 1 to 20 carbon atoms, an aralkyl group having 7 to 38 carbon atoms, an alkenyl group having 2 to 20 carbon atoms, an alkynyl group having 2 to 20 carbon atoms, a dialkylamino group having 2 to 40 carbon atoms, a diarylamino group having 12 to 44 carbon atoms, a diaralkylamino group having 14 to 76 carbon atoms, an acyl group having 2 to 20 carbon atoms, an acyloxy group having 2 to 20 carbon atoms, an alkoxy group having 1 to 20 carbon atoms, an alkoxycarbonyl group having 2 to 20 carbon atoms, an alkoxycarbonyloxy group having 2 to 20 carbon atoms, an alkylsulfonyl group having 1 to 20 carbon atoms, an aromatic hydrocarbon group having 6 to 30 carbon atoms, or an aromatic heterocyclic group having 3 to 16 carbon atoms, and when any one of R⁶ to R¹² represents a phenyl group, the phenyl group may be fused with an aromatic ring substituted with the phenyl group to form a fused ring; and
when Ar¹, Ar², Z, L¹, L², and R⁶ to R¹² represent groups except hydrogen, the groups may each have a substituent.

2. The organic electroluminescent device according to claim 1, wherein H_{A} of the general formula (1) represents a carborane ring-containing group represented by the formula (e1) or the formula (f1).

3. The organic electroluminescent device according to claim 1, wherein in the general formula (1), a represents an integer of from 0 to 2.

4. The organic electroluminescent device according to claim 1, wherein in the general formula (1), p and q each independently represent an integer of from 0 to 3.

5. The organic electroluminescent device according to claim 1, wherein in the general formula (1), r, s, and t each independently represent an integer of from 0 to 3.

6. The organic electroluminescent device according to claim 1, wherein the compound represented by the general formula (1) has a carborane ring-containing group represented by the formula (e1).

7. The organic electroluminescent device according to any one of claims 1 to 6, wherein the organic layer containing the first compound and the second compound is at least one layer selected from the group consisting of a light-emitting layer containing a light-emitting dopant, an electron-blocking layer, and a hole-blocking layer.

8. The organic electroluminescent device according to claim 7, wherein the organic layer is the light-emitting layer containing the light-emitting dopant, and contains the first compound and the second compound as host materials.

9. The organic electroluminescent device according to claim 8, wherein the light-emitting dopant is a delayed fluorescent light-emitting dopant.

10. The organic electroluminescent device according to claim 8, wherein the light-emitting dopant is an organometallic complex containing at least one metal selected from ruthenium, rhodium, palladium, silver, rhenium, osmium, iridium, platinum, and gold.
